(19) **Europäisches Patentamt / European Patent Office / Office européen des brevets**

(11) **EP 1 829 068 B1**

(12) # EUROPÄISCHE PATENTSCHRIFT

(45) Veröffentlichungstag und Bekanntmachung des Hinweises auf die Patenterteilung:
**12.09.2018 Patentblatt 2018/37**

(21) Anmeldenummer: **05850489.5**

(22) Anmeldetag: **22.12.2005**

(51) Int Cl.:
*H01H 1/00* (2006.01)   *H01H 3/00* (2006.01)
*G01R 31/333* (2006.01)

(86) Internationale Anmeldenummer:
**PCT/EP2005/057109**

(87) Internationale Veröffentlichungsnummer:
**WO 2006/069970 (06.07.2006 Gazette 2006/27)**

(54) **VERFAHREN UND VORRICHTUNG ZUM SICHEREN BETRIEB EINES SCHALTGERÄTES**

METHOD AND DEVICE FOR THE SAFE OPERATION OF A SWITCHING DEVICE

PROCEDE ET DISPOSITIF POUR LE FONCTIONNEMENT SUR D'UN APPAREIL DE COMMUTATION

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **23.12.2004 DE 102004062266**
**23.12.2004 DE 102004062267**

(43) Veröffentlichungstag der Anmeldung:
**05.09.2007 Patentblatt 2007/36**

(73) Patentinhaber: **Siemens Aktiengesellschaft**
**80333 München (DE)**

(72) Erfinder:
• **HARTINGER, Peter**
**92439 Bodenwöhr (DE)**
• **MITLMEIER, Norbert**
**92289 Ursensollen (DE)**
• **NIEBLER, Ludwig**
**93164 Laaber (DE)**
• **POHL, Fritz**
**91334 Hemhofen (DE)**
• **ZIMMERMANN, Norbert**
**92237 Sulzbach-Rosenberg (DE)**

(56) Entgegenhaltungen:
**EP-A- 1 298 689    EP-B- 0 832 496**
**US-A- 4 737 749    US-A- 5 455 733**

EP 1 829 068 B1

**Beschreibung**

Die vorliegende Erfindung betrifft ein Verfahren zum sicheren Betrieb eines Schaltgerätes gemäß dem Oberbegriff des Anspruchs 1 sowie eine entsprechende Vorrichtung gemäß dem Oberbegriff des Anspruchs 20.

Mit Schaltgeräten, insbesondere Niederspannungsschaltgeräten, lassen sich die Strombahnen zwischen einer elektrischen Versorgungseinrichtung und Verbrauchern und damit deren Betriebsströme schalten. Das heißt, indem vom Schaltgerät Strombahnen geöffnet und geschlossen werden, lassen sich die angeschlossenen Verbraucher sicher ein- und ausschalten.

Ein elektrisches Niederspannungsschaltgerät, wie beispielsweise ein Schütz, ein Leistungsschalter oder ein Kompaktstarter, weist zum Schalten der Strombahnen einen oder mehrere so genannte Hauptkontakte auf, die von einem oder auch mehreren Steuermagneten gesteuert werden können. Prinzipiell bestehen die Hauptkontakte dabei aus einer beweglichen Kontaktbrücke und festen Kontaktstücken, an die der Verbraucher und die Versorgungseinrichtung angeschlossen sind. Zum Schließen und Öffnen der Hauptkontakte wird ein entsprechendes Ein- oder Ausschaltsignal an die Steuermagnete gegeben, woraufhin diese mit ihrem Anker so auf die beweglichen Kontaktbrücken einwirken, dass die Kontaktbrücken eine Relativbewegung in Bezug auf die festen Kontaktstücke vollziehen und entweder die zu schaltende Strombahnen schließen oder öffnen.

Zur besseren Kontaktierung zwischen den Kontaktstücken und den Kontaktbrücken sind an Stellen, an denen beide aufeinander treffen, entsprechend ausgebildete Kontaktflächen vorgesehen. Diese Kontaktflächen bestehen aus Materialien, wie beispielsweise Silberlegierungen, die an diesen Stellen sowohl auf die Kontaktbrücke als auch die Kontaktstücke aufgebracht sind und eine bestimmte Dicke aufweisen.

Die Materialien der Kontaktflächen sind bei jedem der Schaltvorgänge einem Verschleiß unterworfen. Faktoren, die diesen Verschleiß beeinflussen können, sind:

- zunehmender Kontaktabbrand oder Kontaktabrieb mit steigender Anzahl von Ein- und Ausschaltvorgängen,

- zunehmende Verformungen,

- zunehmende Kontaktkorrosion durch Lichtbogeneinwirkung oder

- Umwelteinflüsse, wie beispielsweise Dämpfe oder Schwebstoffe usw.

Als Folge davon werden die Betriebsströme nicht mehr sicher geschaltet, was zu Stromunterbrechungen, Kontaktaufheizungen oder zu Kontaktverschweißungen führen kann.

So wird sich insbesondere mit zunehmendem Kontaktabbrand die Dicke der an den Kontaktflächen aufgebrachten Materialien verringern. Damit wird der Schaltweg zwischen den Kontaktflächen der Kontaktbrücke und der Kontaktstücke länger, was letztendlich die Kontaktkraft beim Schließen verringert. Als Folge davon werden mit zunehmender Anzahl von Schaltvorgängen die Kontakte nicht mehr richtig schließen. Durch die daraus resultierenden Stromunterbrechungen oder aber auch durch ein verstärktes Einschaltprellen kann es dann zu einer Kontaktaufheizung und damit zu einem zunehmenden Aufschmelzen des Kontaktmaterials kommen, was dann wiederum zu einem Verschweißen der Kontaktflächen der Hauptkontakte führen kann.

Ist ein Hauptkontakt des Schaltgerätes verschlissen oder sogar verschweißt, kann das Schaltgerät den Verbraucher nicht mehr sicher ausschalten. So wird gerade bei einem verschweißten Kontakt trotz des Ausschaltsignals zumindest die Strombahn mit dem verschweißten Hauptkontakt weiter strom- beziehungsweise spannungsführend bleiben, und damit der Verbraucher nicht vollständig von der Versorgungseinrichtung getrennt. Da somit der Verbraucher in einem nicht sicheren Zustand verbleibt, stellt das Schaltgerät eine potentielle Fehlerquelle dar.

Dadurch kann beispielsweise bei Kompaktstartern nach der IEC 60 947-6-2, bei denen ein zusätzlicher Schutzmechanismus auf die selben Hauptkontakte wirkt wie der Steuermagnet beim betriebsmäßigen Schalten, die Schutzfunktion blockiert werden.

Zum sicheren Betrieb von Schaltgeräten und damit zum Schutz des Verbrauchers und der elektrischen Anlage sind deshalb solche Fehlerquellen zu vermeiden.

Aus dem Dokument EP-B-0 832 496 ist ein Verfahren zum sicheren Betriebes eines Schaltgeräts mit zumindest einem ein- und ausschaltbaren Hauptkontakt, welcher ein festes und ein bewegliches Kontaktstück aufweist, und mit zumindest einem Steuermagneten, der einen beweglichen Anker aufweist, wobei der Anker beim Ein- und Ausschalten so auf das bewegliche Kontaktstück wirkt, dass der entsprechende Hauptkontakt geschlossen und geöffnet wird, mit den Schritten:

- Erkennen, ob die bewegliche Kontaktbrücke des zumindest einen Hauptkontaktes nach dem Ausschalten einen Öffnungspunkt überschritten hat,

- Unterbrechung des weiteren Betriebs des Schaltgerätes, wenn nach einer vorgegebenen Zeitdauer der Öffnungspunkt nicht überschritten ist.

Ein ähnlicher Gegenstand ist auch in den Dokumenten US-A-5 455 733 und EP-A-1 298 689 offenbart.

Aus dem DokumentUS-A-4 737 749 S. daneben ein konstruktives Konzept bekannt, welches ein Schaltgerät mit einem Hauptkontakt umfasst, der feste Kontaktstücke und eine bewegliche Kontaktbrücke aufweist.

Nachteilig bei diesen Gegenständen ist, dass bei einem verschweißten Hauptkontakt das zugrunde liegende Schaltgerät, wie oben schon erwähnt, den Verbraucher nicht sicher ausschaltet. Es bleibt zumindest die Strombahn mit dem verschweißten Hauptkontakt weiter strom- beziehungsweise spannungsführend, so dass der Verbraucher nicht vollständig von der Versorgungseinrichtung getrennt ist. Das Schaltgerät stellt damit eine potentielle Fehlerquelle dar.

Aufgabe der vorliegenden Erfindung ist es, solche potentiellen Fehlerquellen zu erkennen und entsprechend darauf zu reagieren.

Diese Aufgabe wird gelöst durch das Verfahren mit den Merkmalen des Anspruchs 1 sowie durch die Vorrichtung mit den Merkmalen des Anspruchs 20. Im Anspruch 39 ist ein geeignetes Schaltgerät zur Durchführung des Verfahrens angegeben. Im Anspruch 40 ist ein geeignetes Schaltgerät mit der erfindungsgemäßen Vorrichtung angegeben. In den Untersprüchen 2 bis 19, 21 bis 38 und 41 sind Verfahrens- und Vorrichtungsvarianten enthalten.

Die vorliegende Erfindung ermöglicht so mit geringem Aufwand, eine Kontaktverschweißung beim Ausschalten und damit einen nicht mehr sicheren Betrieb des Schaltgerätes zu erkennen und entsprechend darauf zu reagieren.

Erfindungsgemäß wird dazu im Betrieb eines Schaltgerätes insbesondere beim Ausschalten erkannt, ob die bewegliche Kontaktbrücke des zumindest einen Hauptkontaktes einen Öffnungspunkt überschreitet. Der weitere Betrieb des Schaltgerätes wird unterbrochen, und zwar insbesondere auch dadurch, dass der Hauptkontakt aufgebrochen wird, wenn nach einer vorgegebenen Zeitdauer der Öffnungspunkt nicht überschritten ist.

Der vorgegebene Öffnungspunkt entspricht dabei einem zuvor ermittelten Öffnungsweg der Kontaktbrücke, bei dem diese gerade noch mit den Kontaktstücken in Verbindung steht. Wird dann nach dem Ausschalten, das heißt nach dem gewollten Öffnen des zumindest einen Hauptkontaktes, ein Öffnungsweg ermittelt, der kleiner ist als dieser vorgegebene Öffnungspunkt, so kann davon ausgegangen werden, dass eine Verschweißung und damit ein nicht sicherer Betrieb des Schaltgerätes vorliegt. Wird das Auftreten eines solchen nicht sicheren Betriebsfalls im laufenden Betrieb überwacht und erkannt, kann rechtzeitig der weitere Betrieb des Schaltgerätes unterbunden werden.

Somit ist mit dem erfindungsgemäßen Verfahren und der erfindungsgemäßen Vorrichtung der sichere Betrieb eines Schaltgerätes, wie zum Beispiel eines Schützes, eines Leistungsschalters oder eines Kompaktabzweig, und insbesondere der sichere Betrieb eines dreipoligen Schaltgerätes gewährleistet. Der sichere Betrieb ist insbesondere dadurch gewährleistet, weil in einem betreffenden Fall mit Sicherheit dafür gesorgt wird, dass keine Strombahn strom- beziehungsweise spannungsführend bleibt.

In einer erfindungsgemäßen Ausgestaltung wird das Überschreiten des Öffnungspunktes durch eine Messung eines Stroms in einer vom Hauptkontakt zu schaltenden Strombahn erkannt, wobei der Öffnungspunkt nicht überschritten ist, wenn der gemessene Strom größer als ein nach dem Ausschalten vorgesehener Strom ist.

Das Überschreiten des Öffnungspunktes kann auch durch eine Messung eines Spannungsabfalls über einen Hauptkontakt erkannt werden, wobei der Öffnungspunkt nicht überschritten ist, wenn der Spannungsabfall kleiner ist als ein nach dem Ausschalten vorgesehener Spannungsabfall.

In einer weiteren Ausgestaltung wird das Überschreiten des Öffnungspunktes durch eine Messung einer Induktivität des Steuermagneten erkannt, wobei der Öffnungspunkt nicht überschritten ist, wenn die Induktivität nach dem Ausschalten einen Wert aufweist, der nicht dem vorgegebenen Wert nach dem Öffnen im Vergleich zum ordnungsgemäßen Betrieb entspricht.

Weiterhin kann der Öffnungspunkt durch einen Zustand von mit der Kontaktbrücke in Wirkverbindung stehenden Mitteln erkannt werden, wobei der erkannte Öffnungspunkt nicht überschritten ist, wenn diese Mittel nach dem Ausschalten in diesem Zustand verbleiben, der nicht dem vorgegebenen Zustand nach dem Öffnen entspricht. Dies ist z. B. bei einer Verschweißung zumindest eines Hauptkontaktes der Fall.

In einer weiteren erfindungsgemäßen Ausgestaltung wird beim Einschalten oder zum Einschalten eines Steuermagneten ein Hilfskontakt geschlossen, wobei beim Einschalten des Steuermagneten dann ein Öffnerkontakt geschlossen wird. Ein Freigabemittel, welches in Reihe zu den Schaltkontakten geschaltet ist, löst dann das Kontaktaufbrechmittel aus, wenn der Hilfskontakt beim Ausschalten im geschlossenen Zustand verbleibt bzw. verblieben ist. Auch in diesem Fall ist von einer Verschweißung oder Verklebung zumindest eines der Hauptkontakte auszugehen.

Insbesondere sind die Schaltkontakte so ausgeführt, dass der Hilfskontakt beim Einschalten vor dem Öffnerkontakt schließt und dass der Öffnerkontakt beim Ausschalten vor dem Hilfskontakt schließt.

In einer weiteren erfindungsgemäßen Ausgestaltung wird bei einer Schaltbetätigung eine magnetische Flussänderung des magnetischen Kreises des Steuermagneten gemessen, wobei der Öffnungspunkt überschritten ist, wenn beim Ausschalten des Steuermagneten die magnetische Flussänderung einen vorgegebenen Vergleichswert überschritten hat. Vorzugsweise wird die magnetische Flussänderung mittels einer Induktionsspule gemessen.

Gemäß einer weiteren erfindungsgemäßen Ausgestaltung wird die elektrische Versorgung für eine Auswerte- und Steuereinheit des Schaltgerätes mittels eines elektrischen Speicherelements, wie z.B. mittels eines Kondensators, einer elektrischen Spule oder eines Akkumulators, für eine Mindestzeit aufrechterhalten, um ein Vorliegen eines verschweißten Hauptkontakts messtechnisch zu prüfen bzw. zu erkennen und um ggf. das Kontaktaufbrechmittel und/oder ein Schaltschloss anzusteuern bzw. freizugeben.

Insbesondere wird der Steuermagnet erst bei Vorliegen eines Schaltbefehls zum Betätigen zumindest eines Hauptkontakts erregt, wenn das elektrische Speicherelement einen Mindestladezustand erreicht hat. Der Mindestladezustand ist dabei so bemessen, dass nach dem Ausschalten des Steuergerätes und insbesondere nach Wegnahme der Schaltspannung zur elektrischen Erregung des Steuermagneten des Schaltgerätes die Auswerte- und Steuereinheit elektrisch versorgt und gegebenenfalls noch den Auslösevorgang starten kann.

In einer weiteren Ausgestaltung der Erfindung wird im eingeschalteten Zustand des Steuermagneten aktiv ein Freigabemittel in einem erregten Zustand gehalten, um die Auslösung des Kontaktaufbrechmittels zu verhindern. Beim Ausschalten werden dann das Freigabemittel und der Steuermagnet entregt, wobei dann ein Anker oder eine mit dem Anker in einer mechanischen Wirkverbindung stehende Komponente des Steuermagneten die Auslösung des Freigabemittels verhindert.

So kann z.B. eine vorgespannte Feder eines Federspeichers durch das Freigabemittel daran gehindert werden, sich zu entspannen. Das Freigabemittel weist dabei auch ein Rückstellmittel auf, wie z.B. eine Rückstellfeder, welche nach Wegnahme der Energiezufuhr zur Aufrechterhaltung des aktiv erregten Zustandes dieses sicher in einen passiven entregten Zustand überführt. Die durch das Rückstellmittel freiwerdende Energie gibt dann die um ein Vielfaches größere gespeicherte Energie im Kontaktaufbrechmittel frei. Diese gespeicherte Energie wird nach Freigabe in einen mechanischen Impuls umgewandelt, der letztlich den verschweißten Hauptkontakt aufbricht.

Insbesondere wird beim Einschalten das Freigabemittel zeitlich vor dem Steuermagneten entregt. Zudem wird beim Ausschalten der Steuermagnet zeitlich vor dem Freigabemittel entregt. Vorzugsweise ist das Freigabemittel ein Hub- oder Tauchmagnet. Das Kontaktaufbrechmittel weist im Besonderen einen Federspeicher, wie z.B. eine zylindrische Druckfeder, auf.

Des Weiteren wird der weitere Schaltbetrieb unterbrochen, indem ein in Reihe mit dem Hauptkontakt in der Strombahn angeordnetes Schaltelement geöffnet wird.

Schließlich wird der weitere Schaltbetrieb unterbrochen, indem zumindest eine Steuerleitung zum Steuern des Steuermagneten unterbrochen wird.

Weitere vorteilhafte Ausführungen und bevorzugte Weiterbildungen der Erfindung sind den Unteransprüchen zu entnehmen.

Das Verfahren zur Bestimmung der Restlebensdauer von Schaltkontakten kann dabei zum einen in der zeitlichen Erfassung vorgegebener diskreter Positionen des Magnetankers des Steuermagneten oder auch mit dem Anker in Wirkverbindung stehenden Komponenten und in der Bestimmung der Geschwindigkeit und der mittleren Beschleunigung des Ankers oder dieser Komponente bestehen, an der die Positionsmessung vorgenommen wird. Zum anderen kann es in der Messung der Einschaltzeitpunkte der Schaltkontakte während ihrer Schließbewegung bestehen.

So werden zur Bestimmung der Restlebensdauer wenigstens vier Zeitpunkte erfasst, von denen einer den Kontaktschließzeitpunkt darstellt und von denen die anderen die Positionszeitpunkte eines oder mehrerer Positionsgeber darstellen. Wenigstens zwei dieser Zeitpunkte können dabei Zeitwerte zweier nah benachbarter Positionen sein, aus welchen dann ein Geschwindigkeitswert des bewegten Bauteiles ableitbar ist. Da das überwachte Bauteil während des Einschaltvorganges im Allgemeinen eine beschleunigte Bewegung ausführt, wird neben diesem so ermittelten Geschwindigkeitswert für wenigstens ein Zeitintervall ein mittlerer Wert einer konstanten Beschleunigung bestimmt. Aus den ermittelten Werten der Geschwindigkeit und der Beschleunigung, sowie aus den Relativpositionen der Positionsgeber zueinander und ihrer Positionszeitpunkte, kann für den Kontaktschließzeitpunkt durch eine einfache mathematische Beziehung die Position des schließenden Kontaktes bestimmt werden. Aus dieser Position lässt sich bestimmen, ob die bewegliche Kontaktbrücke des zumindest einen Hauptkontaktes insbesondere nach dem Ausschalten einen Öffnungspunkt überschritten hat oder nicht. Wird nach einer vorgegebenen Zeitdauer dieser Öffnungspunkt nicht erreicht, so wird der weitere Betrieb des Schaltgerätes unterbrochen.

Für geschwindigkeitsregelbare Schaltgeräte, insbesondere Schütze, die aus einem regelbaren, magnetischen Antrieb bestehen, kann so die mit dem Positionssensor gemessene Geschwindigkeit v genutzt werden, um den Antrieb iterativ auf eine vorgegebene Geschwindigkeit einzustellen oder um die Geschwindigkeit auf ein vorgegebenes Intervall zu beschränken. Dazu werden die Steuerparameter mit jeder Einschaltung des Antriebes mit einem vorgegebenen Parameterschritt in Richtung höhere Geschwindigkeit gestellt, solange die Geschwindigkeit kleiner ist als der Sollwert oder unterhalb des Sollbereiches liegt. Alternativ können die Steuerparameter mit jeder Einschaltung des Antriebes mit einem vorgegebenen Parameterschritt in Richtung kleinere Geschwindigkeit gestellt werden, solange die Geschwindigkeit größer ist als der Sollwert oder oberhalb des Sollbereiches liegt. Damit wird erreicht, dass die Kontakte nach erreichter Geschwindigkeitseinstellung mit der vorgegebenen Geschwindigkeit schließen.

Eine weitere Möglichkeit gemäß der Erfindung besteht in der Erfassung der Bewegkontaktmasse mithilfe eines Kraftsensors. Dieser misst den Kraftstoß, der vom ausschaltenden Antrieb auf den Bewegkontakt übertragen wird. Da die Öffnungsgeschwindigkeit des Bewegkontaktes vom Masseverlust näherungsweise unabhängig ist, erhält man einen zur Masse proportionalen Impuls des Bewegkontaktes und daher einen zur Masse proportionalen Kraftstoß am Kraftsensor. Dieser Kraftstoß wird über einen vorgegebenen Zeitabschnitt nach dem Ausschaltkommando des Antriebs als Kraft-Zeit-Integral ermittelt und erfährt bei einem Materialverlust von beispielsweise 10% eine Abnahme von ebenfalls etwa 10%. Der Mindestwert der verbliebenen Masse an Kontaktmaterial ist hierbei mit einem korrespondierenden Mindestwert der Bewegkontaktmasse verknüpft, welcher nach Erfahrungswerten den Verlust an Kontaktträgermaterial mit einbezieht.

Bei einem Magnetantrieb als Schaltgeräteantrieb kann der Kraftsensor zwischen dem Magnetanker und dem mechanischen Koppelglied, das den Bewegkontakt öffnet, angeordnet sein. Die elektrische Hilfsenergie zu dem Kraftsensor und dessen Messsignal zur Überwachungseinheit können über federnde Kontaktglieder geleitet sein.

Durch Auswertung des entsprechenden Kraftwertsignals kann somit gemäß der Erfindung erkannt werden, ob die bewegliche Kontaktbrücke des zumindest einen Hauptkontaktes insbesondere beim Ausschalten einen Öffnungspunkt überschritten hat. Weicht das Kraftwertsignal von einem vorgegebenen Kraftvergleichswert ab, so wird der weitere Betrieb des Schaltgerätes nach einer vorgegebenen Zeitdauer unterbrochen.

Eine jeweilige Schaltposition des Ankers bzw. eines mit dem Anker in einer Wirkverbindung stehenden Komponenten kann z.B. mittels Kapazitätsmessung eines Messkondensators erfolgen. Der Messkondensator weist dabei zwei Kondensatorplatten auf, die sich entsprechend der Ankerbewegung relativ zu einander bewegen können. Der dadurch resultierende unterschiedliche Kondensatorplattenabstand für zu einer Veränderung der Kapazität des Messkondensators. Zur Bestimmung der Kapazitätszunahme kann mit einer Konstantspannungsquelle ein Ladestrompuls in den Messkondensator eingespeist werden. Dabei ist das Strom-Zeit-Integral des Ladestrompulses proportional zur Kapazitätsänderung und es kann mit den übrigen Kondensatordaten daraus der aktuelle Kontaktdurchdruck berechnet werden. Erreicht der Durchdruckwert einen Mindestwert, so wird das Schaltgerät von der Überwachungseinheit außer Betrieb gesetzt.

Mittels der Kapazitätsänderung kann alternativ erkannt werden, ob die bewegliche Kontaktbrücke des zumindest einen Hauptkontaktes, die mit dem Anker in einer mechanischen Wirkverbindung steht, insbesondere nach dem Ausschalten einen Öffnungspunkt überschritten hat. Der Öffnungspunkt lässt sich dabei rechnerisch aus der Kapazitätsänderung bzw. aus dem Zeitwert ermitteln, der benötigt wird, um den Messkondensator zu laden. Überschreitet dieser Zeitwert einen vorgegebenen Wert, so muss der Messkondensatorplattenabstand sehr klein sein, und es ist davon auszugehen, dass sich der Anker und die damit verbundene Kontaktbrücke nicht mehr geöffnet hat. In diesem Fall ist davon auszugehen, dass eine Verschweißung zumindest eines Hauptkontaktes vorliegt. Der weitere Betrieb des Schaltgerätes wird dann unterbrochen.

Beim Ausschalten hängt die Kontaktöffnungsgeschwindigkeit v empfindlich vom Kontaktdurchdruck D ab, da z.B. bei einem Magnetantrieb sich der Magnetanker und die angekoppelten mechanischen Bauteile aus der Ruhelage (Schließstellung) mit etwa konstanter Beschleunigung b bewegen. Für die Auftreffgeschwindigkeit des Antriebs auf den Bewegkontakt erhält man die Beziehung:

$$v = \sqrt{(2Db)}$$

und damit näherungsweise $v \sim \sqrt{D}$.

Die Erfassung der Geschwindigkeit kann durch den zuvor beschriebenen Messkondensator erfolgen. Da die Öffnungsbewegung des Magnetankers eine Abnahme des Kondensator-Plattenabstandes bewirkt, und dies zu einem Strom i der Konstantspannungsquelle U auf den Messkondensator führt, ergibt sich für den Kontaktdurchdruck D die Beziehung:

t = tö, wobei tö der Zeitpunkt des Öffnungsstoßes auf den Bewegkontakt ist.

Somit kann der Kontaktdurchdruck D nach folgender Gleichung bestimmt werden:

$D = i(t)^2*(2b)^{-1}*(d^2/(\varepsilon AU))^2$, woraus sich wiederum näherungsweise $D \sim i(t)^2$ und damit $\sim i_{max}^2$ ergibt.

In der Gleichung sind dabei die Ankerbeschleunigung b, der Plattenabstand d zum Zeitpunkt des Öffnungsstoßes, die Plattenfläche A, die Konstantspannung U und der Kondensatorstrom $i_{max}$ zum Zeitpunkt tö enthalten. Unterschreitet $i_{max}^2$ einen vorgegebenen Mindestwert, so wird das Schaltgerät von der Überwachungseinheit außer Betrieb gesetzt.

In allen Fällen, in denen die Überwachungseinheit das Schaltgerät außer Betrieb setzt, kann die das Entscheidungskriterium liefernde Messgröße zuvor über eine vorgegebene Anzahl von Messungen gemittelt werden.

Die Schließgeschwindigkeit des Bewegkontaktes ist wegen der dominierenden bewegten Masse des Schaltgeräteantriebes (Magnetanker) von dem verschleißbedingten Masseverlust des Bewegkontaktes praktisch unabhängig. Unter sonst gleichen Verhältnissen ist die Schließgeschwindigkeit daher immer dieselbe. Allerdings wird die Schließgeschwindigkeit mit abnehmendem Kontaktdurchdruck zunehmen, da die Magnetkräfte bei kleinem Ankerluftspalt eine erhebliche Größe erreichen und den Anker deutlich beschleunigen.

Die Masseänderung des Bewegkontaktes spielt im Feder-Masse-System von Bewegkontaktmasse und Kontaktkraft beim Kontaktprellen eine Rolle und kann durch Zeitmessung des Prellvorganges näherungsweise bestimmt werden. Die eventuelle Abnahme der Kontaktkraft mit dem Kontaktabbrand kann bei der Auswertung des Kontaktprellens berücksichtigt werden.

Unter der Annahme, dass beim ersten Prellsprung ein bestimmter Anteil $\alpha$ an kinetischer Energie für die Kontaktabhebung verfügbar ist, folgt für die Kontakt-Abhebegeschwindigkeit $v_{K,A}$ aus der Kontakt-Schließgeschwindigkeit $v_{K,S}$ :

$$v_{K,A} = v_{K,S} * (\alpha)^{-0.5} \, ,$$

und aus der Impulsbeziehung für die Kontaktmasse $m_K$

$$m_K * v_{K,A} = F_K * T/2$$

und

$$\Delta m_K = \Delta T * F_K \, / \, (\, 2 * v_{K,S} * (\alpha)^{-0.5} \,)$$

und damit näherungsweise

$$\Delta m_K \sim \Delta T.$$

$F_K$ ist hierbei die Kontaktkraft und T die Abhebedauer der ersten Prellabhebung.

Durch Mittelung über eine vorgegebene Anzahl von gemessenen Prellzeiten können zufällige Schwankungen ausreichend unterdrückt und eine repräsentative Abhebedauer bestimmt werden. Für die Zeitmessung kann das Kontaktspannungssignal nach dem ersten Schließen der Kontakte ausgewertet werden.

Für eine genauere Auswertung des Masseverlustes $\Delta m_K$ wird der aktuelle Wert der Kontakt-Schließgeschwindigkeit $v_{K,S}$ herangezogen. Dieser kann mit einem Messkondensator bestimmt werden. Zu dem Kontakt-Schließzeitpunkt $t = ts$ fließt aus der Konstantspannungsquelle U der Strom

$$i(t) = -(\varepsilon AU/\, d(t)^2) * v(t)$$

in den Messkondensator. Da d(t) zum Zeitpunkt ts durch die Dicke d der Isolierschicht zwischen den Kondensatorplatten bestimmt ist, ist $v_{K,S} = v(ts)$ bestimmt.

Die Ankerschließgeschwindigkeit v des Magnetantriebes nach der Kontaktberührung hängt empfindlich vom Kontaktdurchdruck D ab, da auf den Magnetanker mit kleiner werdendem Ankerluftspalt immer größere Magnetkräfte einwirken. Man kann den Wert der Ankerschließgeschwindigkeit $v_{K,S}$ zum Zeitpunkt ts der Kontaktberührung als grobes Maß für den Kontaktverschleiß heranziehen. Überschreitet v(ts) einen vorgegebenen Wert, so wird dies mit dem Erreichen des Mindestdurchdruckes gleichgesetzt. Die Geschwindigkeit (Betrag) wird, wie vorausgehend beschrieben, an einem geeigneten Messkondensator bestimmt, nämlich durch:

$$|v_{K,S}| = |v(ts)| = |i(ts) * (\varepsilon AU/\, d(t)^2|.$$

Die Erfindung sowie vorteilhafte Ausführungen derselben werden im Weiteren anhand der nachfolgenden Figuren näher beschrieben. Es zeigen:

FIG 1     ein vereinfachtes Flussdiagramm des erfindungsgemäßen Verfahrens,
FIG 2     eine erste Ausführungsform der erfindungsgemäßen Vorrichtung,
FIG 3     eine zweite Ausführungsform der erfindungsgemäßen Vorrichtung,

FIG 4     eine dritte Ausführungsform der erfindungsgemäßen Vorrichtung.

FIG 5     eine vierte Ausführungsform der erfindungsgemäßen Vorrichtung,

FIG 6     ein zur vierten Ausführungsform gehörendes elektrisches Prinzipschaltbild,

FIG 7     eine fünfte Ausführungsform der erfindungsgemäßen Vorrichtung im Detail,

FIG 8     einen beispielhaften zeitlichen Verlauf eines Öffnerkontaktes und eines dazu in Reihe geschalteten Schließerkontaktes gemäß FIG 6 und FIG7,

FIG 9     ein Schnittbild durch ein Ausführungsbeispiel der erfindungsgemäßen Vorrichtung mit einem Permanentmagnet unterstützten elektromagnetischen Antrieb und einer Messspule,

FIG 10    eine sechste Ausführungsform der erfindungsgemäßen Vorrichtung,

FIG 11    eine siebte Ausführungsform der erfindungsgemäßen Vorrichtung mit geöffneten Hauptkontakten,

FIG 12    die siebte Ausführungsform der erfindungsgemäßen Vorrichtung mit geschlossenen Hauptkontakten.

FIG 13    die siebte Ausführungsform der erfindungsgemäßen Vorrichtung mit einem verschweißten Hauptkontakt mit noch nicht freigegebenem Kontaktaufbrechmittel und

FIG 14    die siebte Ausführungsform der erfindungsgemäßen Vorrichtung mit dem mittels des freigegebenen Kontaktaufbrechmittels aufgebrochenem Hauptkontakt.

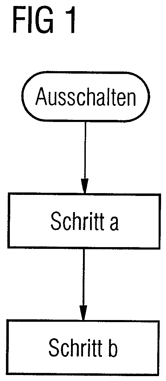

Wie in FIG 1 dargestellt werden bei dem erfindungsgemäßen Verfahren nach einem Ausschaltsignal im Wesentlichen die beiden folgenden Schritte durchgeführt:

Schritt a)    Erkennen, ob die bewegliche Kontaktbrücke des zumindest einen Hauptkontaktes nach dem Ausschalten einen Öffnungspunkt überschritten hat, und

Schritt b)    Unterbrechung des weiteren Betriebs des Schaltgerätes, wenn nach einer vorgegebenen Zeitdauer der Öffnungspunkt nicht überschritten ist.

So wird nach dem betriebsmäßigen Ausschalten, das heißt insbesondere nach einem Ausschaltsignal zum Öffnen der drei Hauptkontakte eines dreipoligen Schaltgerätes, überprüft, ob alle Hauptkontakte des Schaltgerätes geöffnet wurden. Erfindungsgemäß erfolgt dies, indem überprüft wird, ob die beweglichen Kontaktbrücken beim Öffnen einen bestimmten Öffnungsweg zurückgelegt haben, der größer ist als ein im Voraus bestimmter und damit vorgegebener Öffnungspunkt. Ist der erkannte Öffnungsweg einer der Kontaktbrücken auch nach Ablauf einer ebenfalls zuvor festgelegten Zeitdauer nach dem Öffnen immer noch unterhalb dieses Öffnungspunktes, so kann von einer Kontaktverschweißung ausgegangen werden, so dass der weitere Betrieb des Schaltgerätes unterbrochen werden muss.

Die Abfrage der AUS-Position kann bei jedem Schaltvorgang z.B. durch einen in den Steuerstromkreis eingeschleiften zwangsgeführten Kontakt oder über Strommessvorrichtungen, wie z.B. mittels Stromwandler, erfolgen. Die Abfrage kann z.B. auch optisch, magnetisch, induktiv oder kapazitiv erfolgen. Die Auswertung und Steuerung erfolgt vorzugsweise durch eine elektronische Steuereinheit, wie z.B. durch einen Mikrocontroller, wobei nach oder während des Ausschaltvorganges abgefragt wird, ob die Strombahnen geöffnet wurden bzw. ob an der Kontaktstelle nach dem Abschalten noch ein Stromfluss vorliegt.

Liegt ein solcher Fehlerfall vor, so kann die Unterbrechung des weiteren Betriebs beispielsweise durch das Öffnen eines redundanten weiteren geräteinternen Schaltelements erfolgen, das in Reihe mit den Hauptkontakten geschaltet ist. Das Schaltelement trennt dann - unabhängig davon, ob die Hauptkontakte geöffnet oder geschlossen sind - den Verbraucher von der Versorgungseinrichtung. Dadurch, dass das Schaltelement sich nicht ohne weiteres mehr schließen lässt, wird der weitere Betrieb des Schaltgerätes sicher unterbunden. Als Alternative zum Öffnen dieses zusätzlichen Schaltelements kann im Fehlerfall auch die Ansteuerung des Steuermagneten bis zu einer Rücksetzung unterbrochen und damit blockiert werden. Zusätzlich kann geräteintern ein entsprechend starker Kraftspeicher ausgelöst werden, der so auf den oder die verschweißten Hauptkontakte einwirkt, dass diese wieder aufgebrochen und damit geöffnet werden.

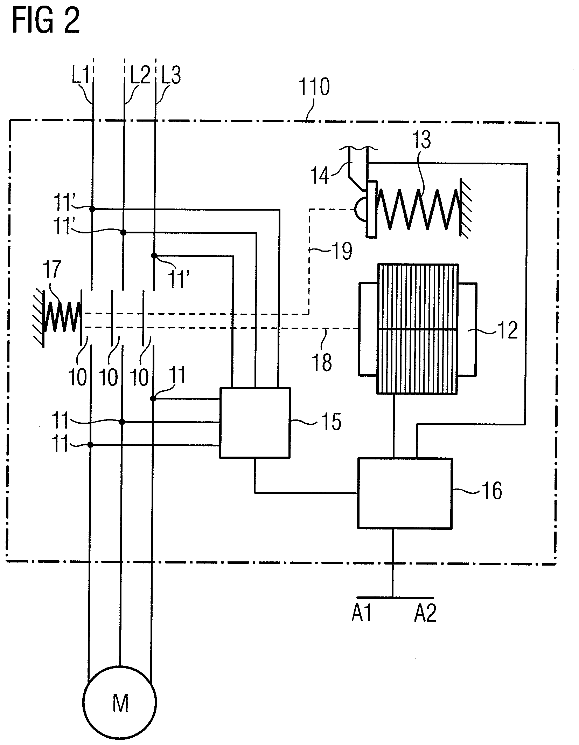

FIG 2 zeigt schematisch ein erstes Ausführungsbeispiel eines Schaltgerätes 110 mit der erfindungsgemäßen Vorrichtung. Die Ein- und Ausschaltsteuersignale zum Ein- und Ausschalten der Hauptkontakte 10 werden über Klemmen A1 und A2 und über eine Steuereinrichtung 16 an den Steuermagneten 12 angelegt. Beim Ausschalten wird der Steuermagnet, der als elektromagnetischer Antrieb 12 für die Hauptkontakte 10 dient, über die Steuereinrichtung 16 entregt. Über die Verbindung 18 wirkt dabei eine Kraft auf die Kontaktbrücken gegen die Kontaktlastfeder 17. Die Hauptkontakte 10 werden so geöffnet, und damit der Verbraucher M von der Versorgungseinrichtung, hier durch die drei Leitungen L1-L3, gekennzeichnet, getrennt.

Nach dem Entregen des Steuermagneten 12 wird zudem von einer Auswerteeinrichtung 15 mittels der Elektroden 11 und 11' überprüft, ob die Kontaktbrücken den vorgegebenen Öffnungspunkt überschritten haben. Zur Messung eines Spannungsabfalls über die Hauptkontakte 10 sind im vorliegenden Ausführungsbeispiel dafür je Strombahn L1-L3 jeweils zwei Elektroden 11 und 11', und zwar einmal vor dem Hauptkontakt 10 und einmal nach dem Hauptkontakt 10, vorgesehen. Erfindungsgemäß wird dann nach dem Ausschalten der Hauptkontakte 10 von der Auswerteeinrichtung 15 über die Elektroden 11 und 11' eine Spannungsprüfung über die Hauptkontakte 10 vorgenommen. Ist der Spannungsabfall an einer der Hauptkontakte 10 zu gering, ist dies ein Indiz dafür, dass dieser nicht weit genug geöffnet hat. Das heißt, der beim Ausschalten von der Kontaktbrücke zurückgelegte Öffnungsweg hat den vorgegebenen Wert nicht überschritten, und es liegt mit hoher Wahrscheinlichkeit eine Verschweißung vor.

Wird nach einer vorgegebenen Zeitdauer, von beispielsweise 100 ms, nachdem ein Ausschaltsignal ausgelöst wurde, weiterhin ein zu geringer Öffnungsweg erkannt, muss sichergestellt werden, dass der weitere Betrieb des Schaltgerätes 110 unterbrochen wird. Im vorliegenden Ausführungsbeispiel ist dafür die Auswerteeinrichtung 15 über eine nicht näher bezeichnete Verbindung mit der Steuereinrichtung 16 verbunden. Wird nun von der Auswerteeinrichtung 15 ein solcher Fehlerfall erkannt, wird dieser an die Steuereinrichtung 16 weitergemeldet, woraufhin diese zumindest eine der Steuerleitungen unterbricht.

Zusätzlich wird im vorliegenden Ausführungsbeispiel eine Auslösemechanik 14 aktiviert, mit der ein Federkraftspeicher 13 entklinkt wird. Solche Federkraftspeicher 13 können zum Beispiel bereits von Leistungsschaltern oder Kompaktstartern bekannte Schaltschlösser sein. Solch ein Schaltschloss schlägt dann mittels einer mechanischen Wirkverbindung 19 mit hoher Kraft auf die nicht geöffneten Hauptkontakte 10 der Schaltstellen des Schaltgerätes 110, um die verschweißten Hauptkontakte 10 aufzubrechen. Um dabei eine Aufbrechung zu erreichen, muss die Kraft des Federspeichers 13 entsprechend groß dimensioniert sein. Der Federspeicher 13 bleibt dann entweder in der ausgeklinkten Stellung und kann nicht mehr zurückgesetzt werden, oder der Federspeicher 13 hat eine Mechanik, mittels der die Feder 13 wieder gespannt und die Auslösemechanik 14 wieder verklinkt werden kann. Da das Zurücksetzen der Mechanik 13 und 14 nur manuell erfolgen kann, wird ein Anwender so auf den Störfall aufmerksam gemacht und muss entsprechend, beispielsweise durch einen Austausch des Schaltgerätes 110, darauf reagieren.

In einem weiteren nicht näher dargestellten Ausführungsbeispiel kann auch nur ein Stromsensor pro Strombahn vorgesehen sein. Dann wird über die Strommessung in jeder der Strombahnen erkannt, ob der Öffnungspunkt nach dem Ausschalten überschritten wurde. Ist anhand der Strommessung erkannt worden, dass eine Überschreitung des Öffnungspunktes nicht stattgefunden hat, wird der weitere Betrieb des Schaltgerätes unterbrochen.

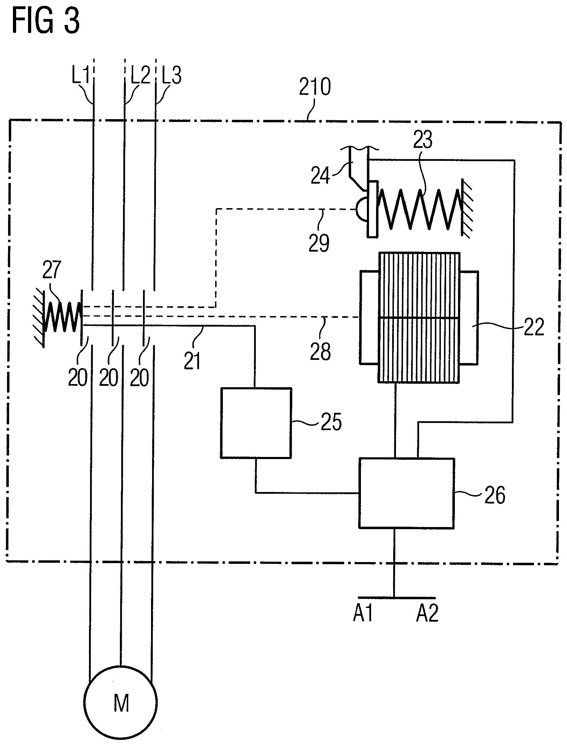

FIG 3 zeigt schematisch ein zweites Ausführungsbeispiel der erfindungsgemäßen Vorrichtung, bei der der zu erkennende Öffnungsweg der Kontaktbrücken der Schaltstelle 20 direkt von der Auswerteeinrichtung 25 abgefragt wird. Dies kann beispielsweise mittels entsprechender, aber in FIG 3 nicht näher dargestellter, Mittel 21 erfolgen. So können beispielsweise Schaltüberwachungsmittel vorgesehen sein, die in einen ersten Zustand überführt werden, wenn die Hauptkontakte 20 beim Einschalten geschlossen werden und die auch nach dem Ausschalten in diesem ersten Zustand verbleiben, wenn zumindest einer der Hauptkontakte 20 verschweißt ist.

Dabei wird davon ausgegangen, dass der erkannte Öffnungsweg den vorgegebenen Wert unterschritten hat, wenn diese Mittel 21 nach dem Ausschalten in diesem ersten Zustand verbleiben, der nicht dem vorgegebenen Zustand nach dem Öffnen entspricht.

Als weiteres und nicht näher dargestelltes Ausführungsbeispiel für die Erkennung des Öffnungsweges der Hauptkontakte wäre auch eine Induktivitätsmessung direkt an der Spule des Steuermagneten denkbar. Der Steuermagnet weist im regulären eingeschalteten Zustand eine andere Induktivität als im ausgeschalteten Zustand auf. Wird diese Induktivität des ausgeschalteten Zustands nach dem Ausschalten nicht erreicht, wird angenommen, dass der Öffnungspunkt nicht überschritten ist, und das Schaltgerät wird abgeschaltet.

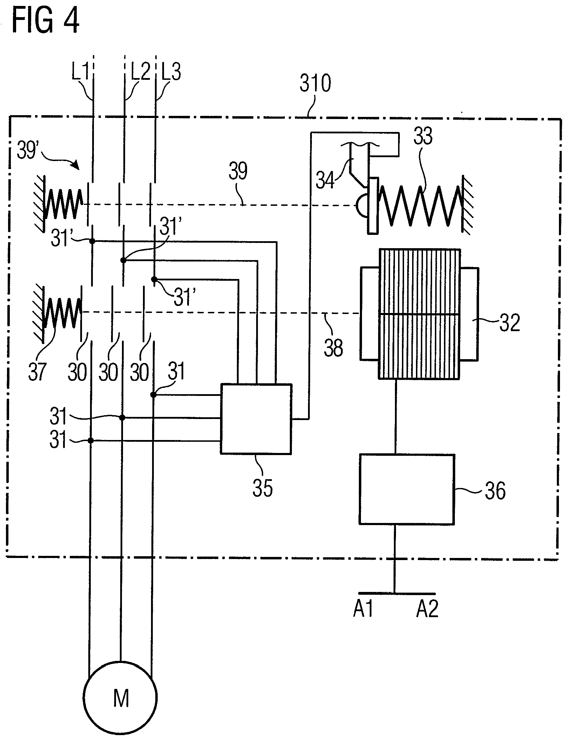

FIG 4 zeigt ein drittes Ausführungsbeispiel der erfindungsgemäßen Vorrichtung. Hier ist im Fehlerfall zum Unterbrechen des weiteren Betriebs ein weiteres Schaltelement 39' vorgesehen, das in den einzelnen Strombahnen L1-L3 in Reihe zu den eigentlich schaltenden Hauptkontakten 30 angeordnet ist. Im Falle der Verschweißung eines der Hauptkontakte 30 erkennt die Auswerteeinrichtung 35 mittels der Elektroden 31 und 31' einen zu geringen Spannungsabfall an diesem Hauptkontakt 30. Als Folge davon bewirkt die Auswerteeinrichtung 35, dass eine Auslösemechanik 34 aktiviert und damit ein Federkraftspeicher 33 entklinkt wird. Dieser Federkraftspeicher 33 wirkt über die Wirkverbindung 39 auf das Schaltelement 39' und öffnet es. Dadurch werden die Strombahnen L1-L3 sicher und unabhängig davon, ob die Hauptkontakte 30 geöffnet oder noch geschlossen sind, unterbrochen, und der weitere Betrieb des Schaltgerätes 310 unterbunden.

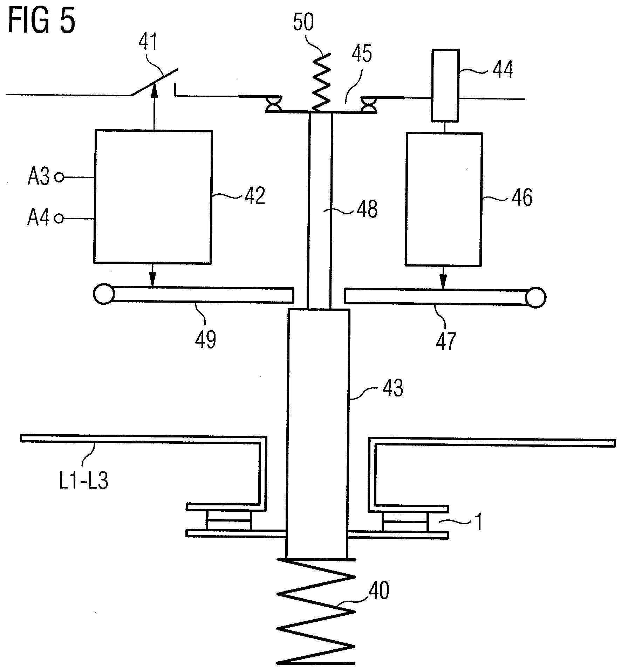

FIG 5 zeigt eine vierte Ausführungsform der erfindungsgemäßen Vorrichtung. Die Vorrichtung weist einen Hilfskontakt als Schaltüberwachungsmittel 45 auf, der in Reihe zu einem Öffnerkontakt 41 eines Steuermagneten 42 bzw. elektromagnetischen Antriebs 42 geschaltet ist. Der Öffnerkontakt 41 wird, wie gezeigt, beim Einschalten, das heißt bei Erregung des Steuermagneten 42, geöffnet. Weiterhin ist in Reihe zum Öffnerkontakt 41 und zum Hilfskontakt 45 ein Aktor 44 geschaltet, welcher im erregten bzw. bestromten Zustand ein Aufbrechmittel 46, wie z.B. einen Kraftspeicher oder, wie in FIG 5 gezeigt, ein Schaltschloss auslösen kann. Der Steuermagnet 42 betätigt über einen Antriebshebel 49 einen Kontaktschieber 43, der die Hauptkontakte 1 öffnen und schließen kann, wobei im erregten Zustand des Steuermagneten 42 die Hauptkontakte 1 im ordnungsgemäßen Betrieb geschlossen sind, in dem eine Kontaktlastfeder 40 die Hauptkontakte 1 schließt. Der Hilfskontakt 45 ist mittels eines Hilfskontaktschiebers 48 und des Kontaktschiebers 43 mit den Hauptkontakten 1 mechanisch verbunden, so dass über diese der Schaltzustand der Hauptkontakte 1 auf den Hilfskontakt 45 "gespiegelt", das heißt übertragen wird. Dabei erfolgt die mechanische Verbindung derart, dass im Falle des Verschweißens zumindest eines Hauptkontakts 1 auch der Hilfskontakt 45 geschlossen ist bzw. geschlossen bleibt.

Erfindungsgemäß wird das Schaltüberwachungsmittels 45 in einen ersten Zustand überführt, wenn die Hauptkontakte 1 beim Einschalten der Vorrichtung geschlossen werden. Der Öffnerkontakt 41 wird geöffnet. Beim Ausschalten wird der Öffnerkontakt 41 geschlossen und das Schaltüberwachungsmittel 45 geöffnet. Dabei verbleibt das Schaltüberwachungsmittel 45 nach dem Ausschalten in diesem ersten Zustand, wenn zumindest einer der Hauptkontakte 1 verschweißt ist.

Ist nun nach dem Ausschalten einer der Hauptkontakte 1 verschweißt, so ist der Öffnerkontakt 41 geschlossen und zugleich auch der Hilfskontakt 45 geschlossen, da trotz Ausschaltbefehl einer der Hauptkontakte 1 geschlossen ist. Über diese beiden geschlossenen Kontakte 41, 45 kann nun der Aktor 44 mit Strom beaufschlagt werden. Der Aktor 44 kann z.B. ein Hubmagnet sein, der dann im stromerregten Fall das Aufbrechmittel 46, wie z.B. einen Federspeicher, freigibt bzw. das Schaltschloss 46 auslöst. Über den Schaltschlosshebel 47 und den Kontaktschieber 43 ist dadurch eine Aufbrechkraft auf den verschweißten Hauptkontakt 1 aufbringbar, so dass die Verschweißung aufgebrochen, und somit der betreffende Verbraucher abgeschaltet werden kann.

Da beim Ausschalten üblicherweise die Schaltspannung "weggenommen" wird, das heißt, dass die Schaltspannung zur elektrischen Versorgung insbesondere des Steuermagneten unterbrochen wird, ist es von Vorteil, wenn die Schaltspannung mittels eines elektrischen Speicherelements, wie z.B. eines Kondensators, gepuffert wird. Die Kondensatorspannung kann dabei mittels einer Diode von der Schaltspannung getrennt werden.

Die Schaltkontakte 41, 45 sind so ausgeführt, dass der Hilfskontakt 45 beim Einschalten schließt, nachdem der Öffnerkontakt 41 geöffnet hat, und dass der Öffnerkontakt 41 beim Ausschalten schließt, nachdem der Hilfskontakt 45 geöffnet hat.

Ohne diese besondere Ausführung der zeitlichen Schaltverzögerung der Schaltkontakte 41, 45 kann es vorkommen, dass im normalen Schaltbetrieb beide Schaltkontakte 41, 45 gleichzeitig, wenn auch nur kurzfristig, geschlossen sind. Die Auswirkung dieses kurzfristigen Schaltzustands, der letztendlich zu einer ungewollten Auslösung des Kontaktaufbrechmittels 46 führen würde, kann dadurch verhindert werden, in dem das durch die beiden geschlossenen Schaltkontakte 41, 45 durchgeschaltete elektrische Auslösesignal zeitlich gefiltert bzw. geglättet wird. Dies ist z.B. mittels einer Drossel, die in Reihe zu den Schaltkontakten 41, 46 geschaltet ist, oder mittels eines Kondensators möglich.

Alternativ kann auch beim Einschalten oder zum Einschalten eines Steuermagneten 42 ein entsprechender Hilfskontakt geöffnet und beim Einschalten des Steuermagneten 42 ein nicht weiter dargestellter Schließerkontakt geschlossen werden. Ein Freigabemittel löst ein Kontaktaufbrechmittel 46 dann aus, wenn der Hilfskontakt beim Ausschalten im geöffneten Zustand verbleibt bzw. verblieben ist, indem der jeweils geöffnete Schaltzustand der besagten Schaltkontakte ausgewertet wird.

Die besagten Schaltkontakte sind vorzugsweise so ausgeführt, dass der Hilfskontakt beim Einschalten öffnet, nachdem der Schließerkontakt geschlossen hat, und dass der Schließerkontakt beim Ausschalten öffnet, nachdem der Hilfskontakt geschlossen hat.

Die besagten Schaltkontakte können z.B. parallel geschaltet sein, wobei im Fehlerfall, das heißt, wenn beide Schaltkontakte geöffnet sind, daraus ein Auslösesignal für das Freigabemittel erzeugt werden kann. Das Auslösesignal kann z.B. mittels der bereits vorhandenen Steuereinheit erzeugt werden.

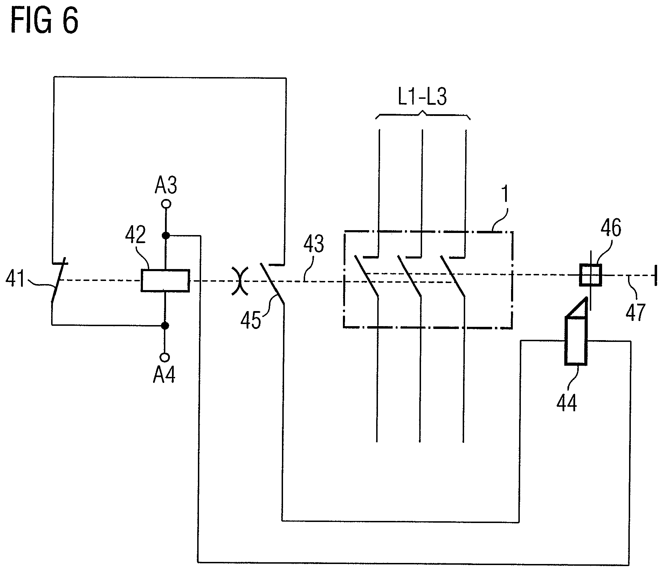

FIG 6 zeigt ein zur vierten Ausführungsform gemäß FIG 5 gehörendes elektrisches Prinzipschaltbild. Im mittleren Teil der FIG 6 sind beispielhaft die drei Hauptkontakte 1 dargestellt, welche mittels des Kontaktschiebers 43 vom Steuermagneten 42 sowie vom Schaltschloss 46 betätigt werden. Parallel zu zwei Anschlussklemmen A3 und A4, über die eine Erregerspule des Steuermagneten 42 mit Strom versorgt werden kann, ist die Reihenschaltung aus dem Öffnerkontakt 41, dem Schaltüberwachungsmittel 45 und dem Aktor 44 zur Freigabe des Schaltschlosses 46 dargestellt. Wird nun an die Klemmen A3 und A4 eine Schaltspannung zum Einschalten der Vorrichtung angelegt, so wird die Erregerspule des Steuermagneten 42 mit einem Strom durchflossen, um den Hauptkontakt 1 zu schließen. Im Fehlerfall, das heißt bei einem verschweißten Hauptkontakt 1, bleibt allerdings auch der Hilfskontakt 45 bzw. das Schaltüberwachungsmittel geschlossen, so dass nun der Aktor 44 zur Freigabe des Schaltschlosses 46 mit Strom versorgt werden kann. In diesem Fall dient die an den Klemmen A3, A4 anliegende Schaltspannung zur Stromversorgung des Aktors 44. Eine Vorrichtung dieser Art ist sozusagen inhärent sicher bis zum Lebensdauerende und erreicht einen sicheren Schaltzustand.

Die Schaltvorrichtung kann besonders vorteilhaft in einem Kompaktstarter verwendet werden, bei dem sowohl die Kontaktöffnung beim betriebsmäßigen Schließen als auch eine Abschaltung bei Überstrom nur durch eine Hauptkontaktanordnung erfolgen.

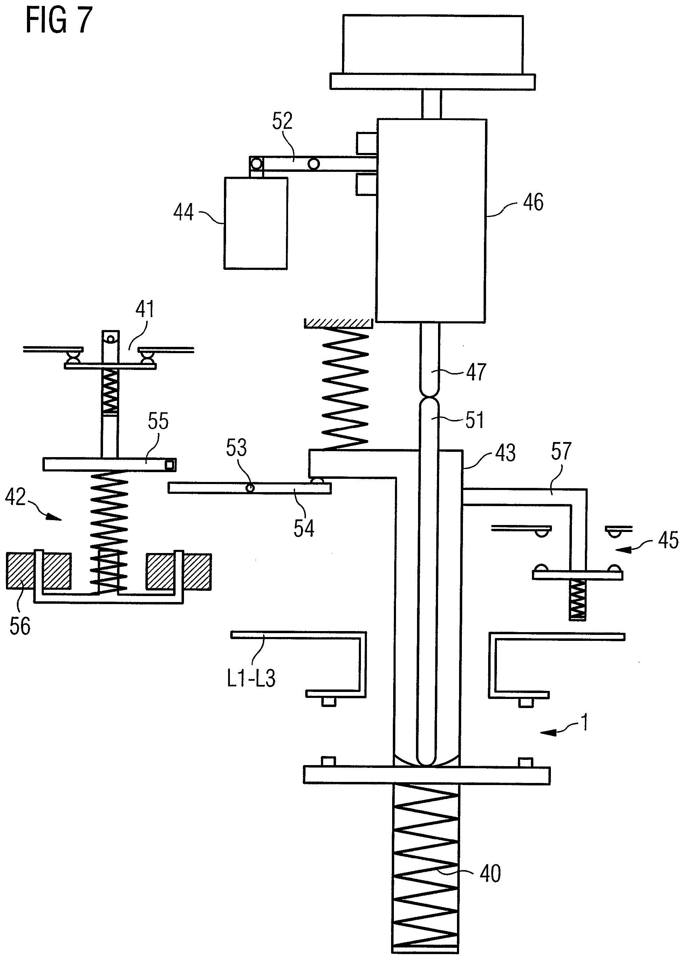

FIG 7 zeigt eine fünfte Ausführungsform der erfindungsgemäßen Vorrichtung im Detail. Im oberen Teil der FIG 7 ist ein Schaltschloss 46 mit einem integrierten Federspeicher als Kraftelement zum Aufbrechen eines verschweißten Hauptkontakts 1 dargestellt. Das kombinierte Schaltschloss 46 wirkt im Falle einer Auslösung über beispielhaft zwei mechanisch miteinander in einer Wirkverbindung stehenden Stößeln 47, 51 direkt auf die bewegliche Kontaktbrücke. Ein verschweißter Hauptkontakt 1 kann dadurch aufgebrochen werden. Ein Aktor 44 als Auslöseeinheit ist mittels eines beispielhaften drehbar gelagerten Hebels 52 mit dem Schaltschloss 46 verbunden. Der Aktor 44 ist vorzugsweise ein Tauchanker oder ein Hubmagnet. Zum Auslösen wird der Aktor 44 mit Strom versorgt. Dies erfolgt in analoger Weise wie in der Vorrichtung gemäß FIG 5 und FIG 6. Das heißt, wenn das Freigabemittel 45 bzw. der Hilfskontakt und der Öffnerkontakt 41 des Steuermagneten 42 zum betriebsmäßigen Schalten des Schaltgerätes geschlossen sind. In diesem Fall wird der Aktor 44 über die an der Erregerspule 56 des Steuermagneten 42 anliegende Spannung mit Strom versorgt. Im linken Teil der FIG 7 ist der Steuermagnet 42 zu sehen. Beim Einschalten wird der Anker 55 des Steuermagneten 42 angezogen, wobei der Anker 55 dann einen drehbar 53 gelagerten Antriebshebel 54 betätigt. Im normalen Betriebsfall wird durch diese Betätigung der Kontaktschieber 43 nach "oben" bewegt, so dass die Hauptkontakte 1 mittels der Federkraft der Kontaktlastfeder 40 geschlossen werden können. Die Federkraft der Kontaktlastfeder 40 ist dabei so ausgelegt, dass die beim Auslösen des Schaltschlosses 46 mit dem integrierten Kraftelement freigegebene Kraft deutlich größer ist, um die erforderliche Aufbrechkraft für den verschweißten Hauptkontakt auch die Federkraft der Kontaktlastfeder 40 überwinden zu können.

In einer besonderen Ausführungsform ist für das sichere Auslösen des Kraftelements 46 vorgesehen, dass der Öffnerkontakt 41 und das als Schaltkontakt ausgebildete Freigabemittel 45 in zeitlicher Hinsicht korrekt zueinander betätigt werden. So ist es vorteilhaft, wenn beim Einschalten der Öffnerkontakt 41 zeitlich vor dem Schließen des Freigabemittels 45 öffnet und wenn beim Ausschalten der Öffnerkontakt 41 zeitlich nach dem Öffnen des Freigabemittels 45 schließt.

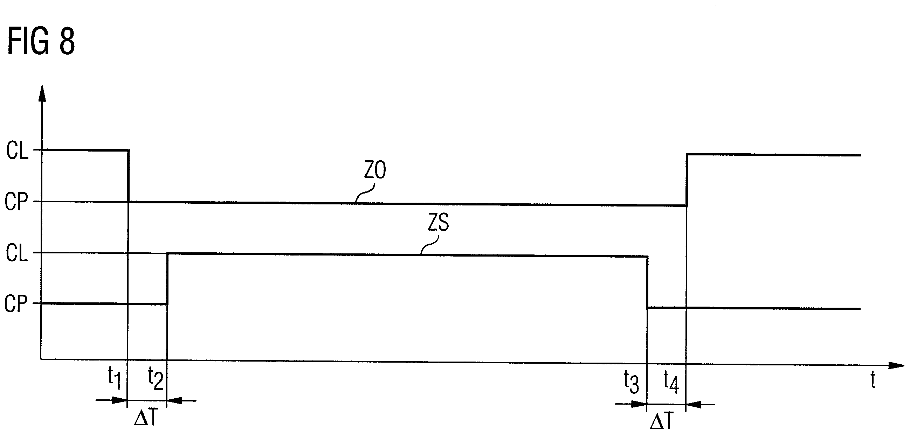

Dies ist in der nachfolgenden FIG 8 dargestellt, wobei ZO den zeitlichen Verlauf des Öffnerkontakts 41 und ZS den zeitlichen Verlauf des als Schließerkontakt ausgebildeten Freigabemittels 45 bezeichnet. Mit dem Bezugszeichen CL ist der geschlossene Zustand und mit dem Bezugszeichen OP der geöffnete Zustand des betreffenden Schaltkontakts 41, 45 bezeichnet. Mit ∆T ist der Zeitversatz zwischen den Schaltflanken der zeitlichen Verläufe ZO und ZS beispielhaft gekennzeichnet. Durch diese gezielte zeitliche Verzögerung der Schalthandlungen erübrigen sich die in der Figurenbeschreibung zur FIG 5 notwendigen Filter- und Glättungselemente.

Alternativ können auch der Öffnerkontakt als Schließer und das Freigabemittel als Öffner ausgebildet sein. Vorzugsweise sollten die beiden Schalter 41 und 45 im ordnungsgemäßen Betrieb der Vorrichtung sowohl im eingeschwungenen eingeschalteten, als auch im eingeschwungenen ausgeschalteten Zustand gegensätzliche Kontaktstellungen aufweisen, d.h. Schalter 41, 45 "geöffnet/geschlossen" bzw. "geschlossen/geöffnet". Dies kann z.B. auf mechanischem Wege mittels Dämpfer oder auf elektrischem Wege mittels elektrischer Verzögerungsglieder erfolgen, welche unterschiedliche Zeitkonstanten für das Ein- und Ausschalten aufweisen.

Des Weiteren kann die Schaltspannung zum Ein- und Ausschalten des Schaltgerätes, welche an den elektrischen Anschlüssen A3 und A4 zur Erregung der Erregerspule 56 des Steuermagneten 42 anliegt, über eine Diode zur Spannungsentkopplung und über einen nachgeschalteten Kondensator gepuffert werden. Dadurch steht eine ausreichende elektrische Energie zur Auslösung des Kraftelements 46 bzw. des Schaltschlosses 46 bei Wegnahme der Schaltspannung zum Ausschalten der Vorrichtung in einem Fehlerfall zur Verfügung.

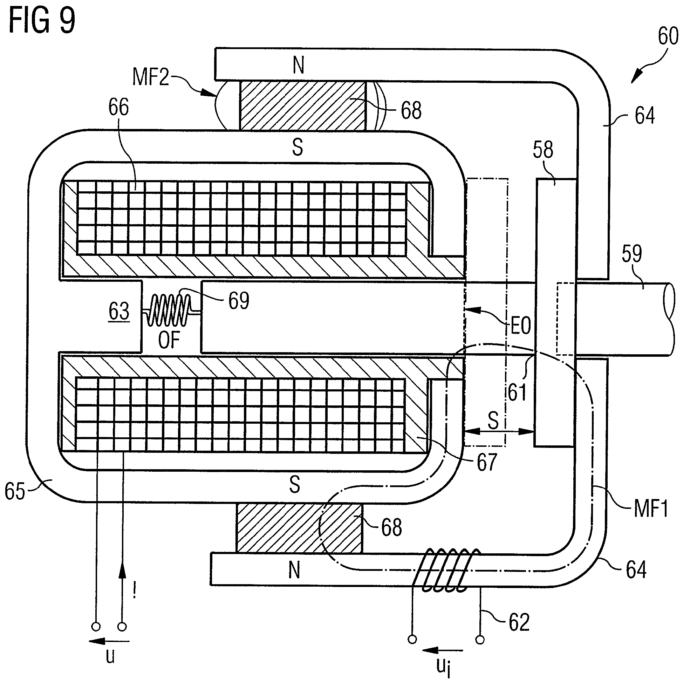

FIG 9 zeigt ein Schnittbild durch ein Ausführungsbeispiel der erfindungsgemäßen Vorrichtung mit einem Permanentmagnet 68 unterstützten elektromagnetischen Antrieb 60.

In der oberen Hälfte ist dabei der magnetische Fluss im elektromagnetischen Antrieb 60 im EIN-Zustand dargestellt (siehe gestrichelte dargestellte Anschlagplatte 58). Im unteren Teil der FIG 9 ist dagegen der magnetische Fluss im elektromagnetischen Antrieb 60 im AUS-Zustand dargestellt (siehe durchgezeichnet dargestellte Anschlagplatte 58).

In der Bildmitte ist eine Erregerspule 66 gezeigt, welche auf einem Wickelkörper 67 aufgewickelt ist. Die Erregerspule 66 weist beispielhaft zwei Anschlüsse zur Einspeisung eines Spulenstroms i auf. Mit dem Bezugszeichen u ist die an der Erregerspule 66 anliegende Spulenspannung als Schaltspannung bezeichnet. Der Wickelkörper 67 und die Erregerspule 66 bilden eine zylindrische Öffnung OF aus, in welcher sich ein Anker 61 des elektromagnetischen Antriebs 60 bewegen kann. Der Anker 61 weist einen auf die Abmessungen der zylindrischen Öffnung OF abgestimmten zylindrischen Bolzen sowie eine daran angebrachte Anschlagplatte 58 auf. Der gesamte Anker 61 ist dabei aus einem ferromagnetischen und insbesondere weichmagnetischen Werkstoff, wie z.B. aus Eisen, hergestellt. Der Wickelkörper 67 und die Erregerspule 66 sind von einem inneren Joch 65 aus einem weichmagnetischen Werkstoff zur magnetischen Flussführung des von der Erregerspule 67 erzeugten Magnetfeldes umgeben, wobei ein Teil des inneren Jochs 65 sich in die zylindrische Öffnung OF erstreckt und dort einen inneren Pol 63 ausbildet. Das so erzeugte Magnetfeld wirkt letztlich im gezeigten Bereich der zylindrischen Öffnung OF.

Der elektromagnetische Antrieb 60 wird durch zumindest einen Permanentmagneten 68 unterstützt, so dass eine in der AUS-Position des elektromagnetischen Antriebs 60 zusätzliche Haltekraft auf den Anker 61 erzeugt wird. Die Permanentmagnete 68 sind dabei an der Außenseite des inneren Jochs 65 des elektromagnetischen Antriebs 60 angebracht. Die magnetischen Pole der beiden Permanentmagnete 68 sind jeweils mit N und S bezeichnet. Die Permanentmagnete 68 sind vorzugsweise entlang des Umfangs des inneren Jochs 65 angeordnet. Anstelle einer Vielzahl von Permanentmagneten 68 kann auch ein magnetischer Ring bzw. Reif verwendet werden, der so polarisiert ist, dass sich an dessen Innenseite ein Nordpol N bzw. Südpol S und an dessen Außenseite sich ein Südpol S bzw. Nordpol N ausbildet. Die nach außengerichtete Seite der Permanentmagnete 68 sind im Beispiel der FIG 9 mit einem topfförmigen weichmagnetischen äußeren Joch 64 verbunden. Das äußere Joch 64 weist gleichfalls eine zylindrische Öffnung auf, in welcher ein Kontaktschieber 59 geführt ist. Der Kontaktschieber 59 ist mittels der Anschlagplatte 58 des Ankers 61 betätigbar, so dass eine mit dem Kontaktschieber 59 verbundene nicht näher dargestellte Kontaktbrücke betätigt werden kann.

Weiterhin ist im Inneren der zylindrischen Öffnung OF zwischen dem inneren Pol 63 und dem zylindrischen Bolzen des Ankers 61 eine Rückstellfeder 69 eingebracht, welche im stromlosen Zustand der Erregerspule 66 den Anker 61 aus der zylindrischen Öffnung OF treibt. Die geometrischen Abmessungen des zylindrischen Bolzens des Ankers 61, die Außenseite des inneren Jochs 65 sowie die Innenseite des äußeren Jochs 64 sind geometrisch so aufeinander abgestimmt, dass die Anschlagplatte 58 des Ankers 61 in einer erregten EIN-Position gegen die Außenseite des inneren Jochs 65 schlägt und im entregten Zustand gegen die Innenseite des äußeren Jochs 64 anschlägt. Die gestrichelte Darstellung der Anschlagplatte 58 zeigt dabei die EIN-Position des elektromagnetischen Antriebs 60 an.

In der unteren Hälfte der FIG 9 ist für die AUS-Position des elektromagnetischen Antriebs 60 der Verlauf des von den Permanentmagneten 68 herrührenden magnetischen Feldes MF1 als Punktstrichlinie eingezeichnet. In der oberen Hälfte der FIG 9 ist zum Vergleich der Verlauf des von den Permanentmagneten 68 herrührenden magnetischen Feldes MF2 für die EIN-Position des elektromagnetischen Antriebs 60 eingezeichnet. Im letzteren Fall findet sich kein Weg mit einem geringen magnetischen Widerstand für das magnetische Feld MF2 über das äußerer Joch 64, so dass sich zwangsläufig ein magnetisches Streufeld um den jeweiligen Permanentmagnet 68 ausbildet.

Durch die permanentmagnetische Fesselungskraft auf den Anker 61 erfolgt der Umschaltvorgang schlagartig, so dass im Losbrechzeitpunkt die Bewegung des Ankers 61 im Vergleich zu reinen elektromagnetischen Antrieben sofort und mit voller Kraft erfolgt.

Gemäß der Erfindung kann nun eine Änderung des magnetischen Flusses insbesondere außerhalb der Erregerspule 66 und insbesondere außerhalb des die Erregerspule 66 umgebenden inneren Jochs 65 des elektromagnetischen Antriebs 60 mittels eines geeigneten Messmittels erkannt werden. Im Beispiel der FIG 9 ist dazu eine besonders vorteilhafte Messspule 62 um einen Schenkel des äußeren Jochs 64 gewickelt. Anstelle der Messspule 62 kann auch ein Magnetfeldsensor, wie z.B. ein Hallsensor, verwendet werden. Ausgehend von der AUS-Position durchfließt der magnetische Fluss MF1 die Messspule 62 stationär. Bewegt sich nun der Anker 60 schlagartig nach links in die EIN-Position, so verändert sich auch schlagartig der Verlauf des magnetischen Flusses in der Art, dass sich ein Streufeld MF2 gemäß der Darstellung der FIG 9 auch im unteren Bereich ausbildet, wobei zugleich der magnetische Fluss im äußeren Joch 65 nahezu verschwindet. Diese dynamische Änderung des magnetischen Flusses im Schenkel des äußeren Jochs 65 äußert sich in einer an den Anschlüssen der Messspule 62 anliegenden Induktionsspannung $u_i$, deren Spitzenwert umso größer ist, je schneller der magnetische Fluss sich ändert.

Die Induktionsspannung $u_i$ kann nun mit einem vorgegebenen Vergleichswert verglichen werden und aus dem Vergleichsergebnis ein digitales Signal zur signaltechnischen Weiterverarbeitung generiert werden.

Erfindungsgemäß wird durch das Vorliegen eines Mindestwertes der Induktionsspannung $u_i$ erkannt, dass die bewegliche Kontaktbrücke des zumindest einen Hauptkontaktes nach dem Ausschalten einen Öffnungspunkt überschritten haben muss. Wird dagegen der Mindestwert der Induktionsspannung $u_i$ nach einer vorgegebenen bzw. innerhalb der vorgegebenen Zeitdauer nicht erkannt, so wird der weitere Betriebs des Schaltgerätes unterbrochen. In diesem Fall kann davon ausgegangen werden, dass eine Kontaktverschweißung vorliegen muss, die dazu führt, dass die Ankerplatte 58 nun nicht vollends an dem inneren bzw. äußeren Joch 65, 64 anliegt. Entsprechend geringer ist die erzeugte Induktionsspannung $u_i$.

Ein besonderer Vorteil dabei ist, dass auch schleichende Verschleißerscheinungen der Antriebsmechanik des elektromagnetischen Antriebs 60 festgestellt werden können, die dann zu langsamer werdenden Schaltbetätigungen mit einer geringeren Induktionsspannung $u_i$ führen.

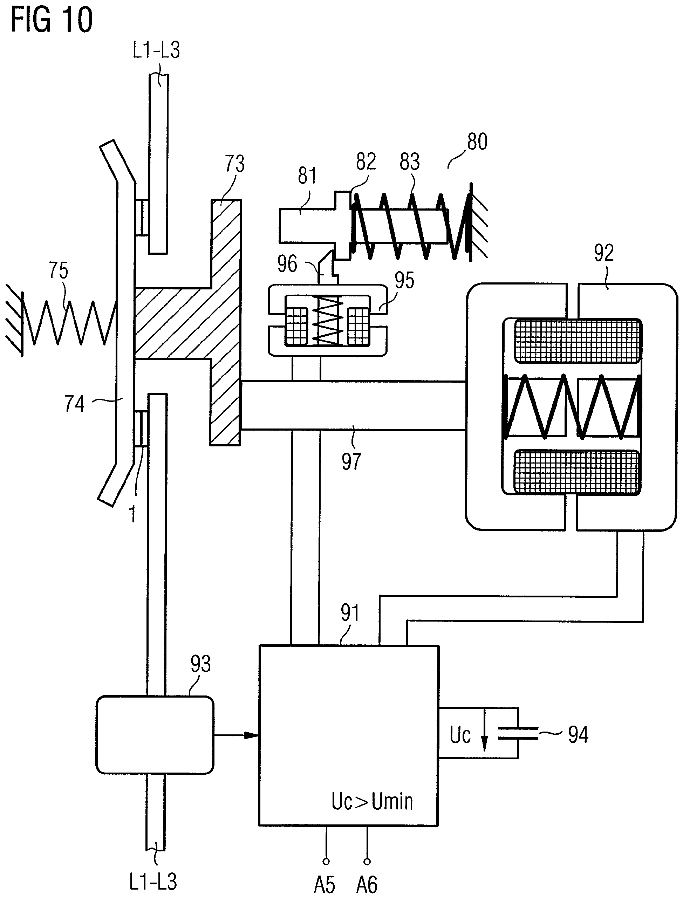

FIG 10 zeigt eine sechste Ausführungsform der erfindungsgemäßen Vorrichtung.

Der wesentliche Aspekt der Vorrichtung gemäß FIG 10 ist, dass eine Energiepufferung während des Betriebs erfolgt, so dass beim Ausschalten und somit nach Wegnahme der Energieversorgung die elektrische Versorgung einer Auswerte- und Steuereinheit noch für eine Mindestzeit gewährleistet werden kann, um gegebenenfalls bei Vorliegen eines verschweißten Hauptkontakts ein Kontaktaufbrechmittel und/oder Schaltschloss ansteuern bzw. freigegeben zu können.

Bei der vorliegenden Vorrichtung gemäß FIG 10 ist beispielhaft ein elektrischer Energiespeicher 94 in Form eines Kondensators vorhanden. Dieser wird zunächst beim Anlegen einer Versorgungsspannung an die Auswerte- und Steuerreinheit 91 über die Steuerklemmen A5, A6 aufgeladen. Erst wenn der Energiespeicher 94 einen Mindestladezustand erreicht hat, wird ein elektromagnetischer Antrieb 92, wie z.B. ein Steuermagnet, zum Einschalten der Hauptkontakte 1 angesteuert. Bei einem Kondensator 94 entspricht der Mindestladezustand des elektrischen Energiespeichers 94 einer Mindestladespannung Umin für die Kondensatorspannung Uc. Diese kann z.B. 80% der an den Klemmen A5, A6 anliegenden Schaltspannung betragen. Der Mindestladezustand des Energiespeichers 94 ist dabei so bemessen, dass diese zur Auslösung des Kontaktaufbrechmittels 80 durch die Auswerte- und Steuerreinheit 91 mittels eines Steuersignals an ein Freigabemittel ausreichend ist.

Der gezeigte Steuermagnet 92 betätigt bei Ansteuerung zum Einschalten des Schaltgerätes einen Anker 97, der in einer mechanischen Wirkverbindung mit einem Kontaktschieber 73 steht, der seinerseits auf eine Kontaktbrücke 74 wirkt. Die Kontaktbrücke 74 überbrückt dann als bewegliches Leitungsstück die feststehenden Leitungsstücke der Strombahnen L1-L3. Beim Einschalten des Steuermagneten 92 wird eine im ausgeschalteten Zustand des Schaltgerätes vorgespannte Kontaktlastfeder 75 entspannt, die dann die Kontaktbrücke 74 gegen die feststehenden Leitungsstücke der Strombahnen L1-L3 drückt und dies kontaktiert. Alternativ oder zusätzlich kann zum Aufbrechen eines verschweißten Hauptkontakts 1 auch ein Schaltschloss angesteuert werden, welches konstruktiv dazu ausgebildet ist, um in der Regel einen verschweißten Hauptkontakt 1 aufbrechen zu können.

Mit dem Bezugszeichen 93 sind Mittel zum Erkennen zumindest eines verschweißten Hauptkontakts 1 bezeichnet. Die Mittel dienen gemäß der Erfindung zum Erkennen, ob die bewegliche Kontaktbrücke 74 des zumindest einen Hauptkontaktes 1 nach dem Ausschalten einen Öffnungspunkt überschritten hat. Im Beispiel der FIG 10 ist das Mittel 93 ein Stromsensor, insbesondere ein 3-fach-Stromsensor zur Erfassung des Stromflusses in den Hauptstrombahnen L1-L3 eines 3-poligen Schaltgerätes. Der Stromsensor 93 ist dabei über eine Verbindungsleitung zur Ausgabe eines Strommesswertes mit der Auswerte- und Steuereinheit 91 verbunden.

Erfindungsgemäß wird der weitere Betrieb des Schaltgerätes unterbrochen, wenn nach einer vorgegebenen Zeitdauer der Öffnungspunkt nicht überschritten ist. Im Beispiel der vorliegenden FIG 10 wertet die Auswerte- und Steuereinheit 91 dazu den Stromfluss in den Strombahnen L1-L3 innerhalb der vorgegebenen Zeitdauer, wie z.B. von 100 ms, nach dem Ausschalten des Steuergerätes aus. Wird ein Stromfluss festgestellt, so gibt die Auswerte- und Steuereinheit 91 einen Stromimpuls an das Freigabemittel 95 aus. Das Freigabemittel 95 ist z.B. ein Aktor in Form eines Hub- oder Tauchmagneten, dessen Aktoranker 96 das Freigabemittel 80 in Form eines Federspeichers freigibt. Hierzu rückt der als Sperrzahn ausgebildete Aktoranker 96 aus einem Rückhaltesteg 82 eines durch eine Feder 83 vorgespannten Aufbrechkontaktschiebers 81 aus. Dieser Aufbrechkontaktschieber 81 schlägt dann auf den Kontaktschieber 73 zum Aufbrechen des verschweißten Hauptkontakts 1.

Alternativ könnte über eine messtechnische Rückkopplung die Induktivität des elektromagnetischen Antriebes und somit die AUS-Stellung der Hauptkontakte 1 ermittelt werden. Oder es könnte über einen Hilfsschalter, wie z.B. einem Spiegelkontakt nach IEC 60947-4-1, der elektrisch mit der Auswerte- und Steuereinheit 91 verbunden ist, ermittelt werden, ob die Hauptkontakte 1 geöffnet haben. Wird festgestellt, dass die Hauptkontakte 1 nicht geöffnet sind, so wird der Energiespeicher 94 über das Freigabemittel 95 entladen.

Besonders hohe technische Anforderungen sind an die Zuverlässigkeit des Energiespeichers nach einer langen Betriebszeit von vielen Jahren gegebenenfalls unter hohen Umgebungstemperaturen zu stellen. Vorstellbar wäre der Einsatz von Kondensatoren, die für den Einsatz im militärischen Bereich ausgelegt sind. Diese weisen eine deutlich längere Lebensdauer als konventionelle Kondensatoren auf. Der elektrische Kondensator 94 könnte mittels einer geeigneten Ladeschaltung aus der beim Ausschaltvorgang des Schaltgerätes induzierten elektrischen Spannung in der Erregerspule des Steuermagnetes 92 geladen werden. Diese gespeicherte elektrische Energie steht dann für die nachfolgende kurze Zeitspanne für die Versorgung der Auswerte- und Steuereinheit 91 sowie zur Auslösung des Freigabemittels 95 zur Verfügung.

Anstelle von elektrischen Kondensatoren wäre auch ein kleines Schwungrad vorstellbar, dessen kinetische Energie mittels eines Dynamos nach dem Ausschalten als elektrische Energie zur Verfügung steht.

Alternativ könnten der oder die Stromwandler 93 derart größer dimensioniert werden, dass über die Stromwandler 93 von den Hauptstrombahnen L1-L3 die Energie abgezapft werden kann, die zum Betreiben der Auswerte- und Steuereinheit 91 und zum Auslösen des Freigabemittels 95 benötigt wird.

Vorstellbare wäre auch eine Lösung, bei der die Auswerte- und Steuereinheit 91 neben den Klemmen A5, A6 noch zusätzliche Stromversorgungsklemmen aufweist. Wird die Spannung von diesen zusätzlichen Stromversorgungsklemmen abgegriffen, so wird die Auswerte- und Steuereinheit 91 auch nach dem Ausschalten von dieser unabhängigen Stromversorgung mit Energie versorgt.

Für das Aufbrechen eines verschweißten Hauptkontakts 1 ist eine besondere Schaltschlosskonstruktion von Vorteil, die im Bereich der Kontaktberührung entweder eine hohe Öffnungskraft und/oder einen hohen Öffnungsimpuls hat. Durch ein entsprechendes Übersetzungsgetriebe kann erreicht werden, dass die in einer Ausschaltfeder gespeicherte Energie nicht linear über den Öffnungsweg abgebaut wird, sondern vornehmlich über den Weg von der Stellung "EIN" bis zur Stellung "Kontaktberührung". Nach der Stellung "Kontaktberührung" bis zur Stellung "AUS" wird dann noch die verbleibende Energie abgegeben, um die Kontaktlastfedern in die Schaltposition "AUS" vorzuspannen.

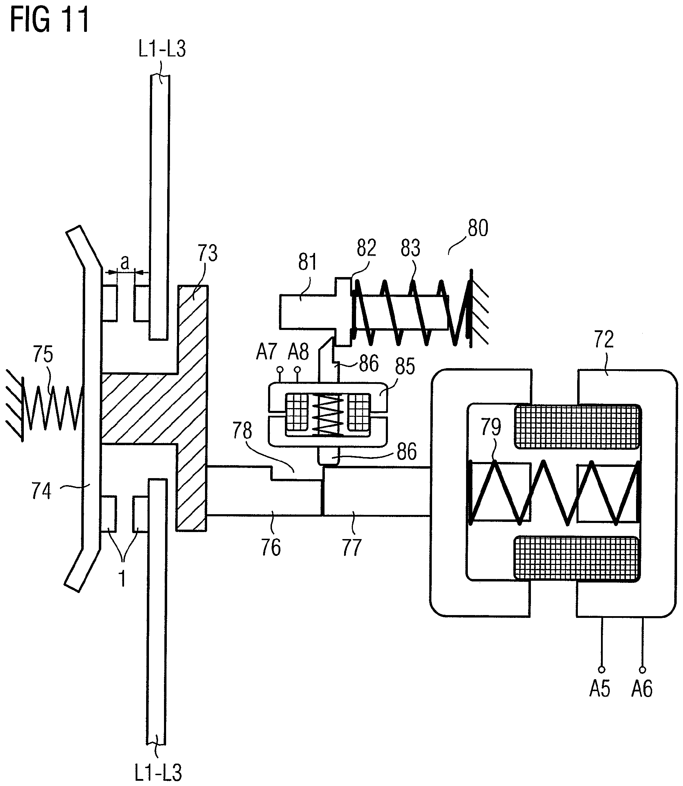

FIG 11 zeigt eine siebte Ausführungsform der erfindungsgemäßen Vorrichtung mit geöffneten Hauptkontakten 1. Es wird angenommen, dass die Hauptkontakte 1 noch nicht verschlissen sind und ordnungsgemäß geöffnet haben.

Die vorliegende FIG 11 zeigt im rechten Teil einen Steuermagneten 72 im ausgeschalteten entregten Zustand. In diesem Fall drückt die Rückstellfeder 79 des Steuermagneten 72 eine Kontaktbrücke 74 über einen Anker 77 und über einen in einer mechanischen Wirkverbindung stehenden Kontaktschieber 73 in die AUS-Stellung. Dabei wird eine im Vergleich zur Rückstellfeder 79 kräftemäßig schwächere Kontaktlastfeder 75 vorgespannt. Im gezeigten Zustand weisen die Hauptkontakte 1 nun einen Kontaktöffnungsabstand a auf. Ein Stromfluss durch die Strombahnen L1-L3 ist somit nicht möglich.

Beim Ausschalten wird der Anker 77 des Steuermagneten 72 auf ein Verbindungsstück 76, welches fest mit dem Kontaktschieber 73 verbunden ist. Kontaktschieber 73 und Verbindungsstück 76 können auch als ein Bauteil ausgebildet sein. Im gezeigten AUS-Zustand liegt an dem Ende des Ankers 77, welches dem Steuermagneten 72 gegenüberliegt, seitlich ein Aktoranker 86 eines entregten Aktors 85 an. Der Aktor 85 dient als Freigabemittel für das Kontaktaufbrechmittel 80. Der Anker 77 wirkt im gezeigten Zustand als Anschlag, so dass der am gegenüberliegenden Ende des Aktorankers 86 ausgebildete Sperrzahn nicht aus einem Rückhaltesteg bzw. Rückhalterand 82 des Kontaktaufbrechmittels 80 ausrücken kann. Eine Rückstellfeder des Aktors 85 bleibt dabei durch den Rückhalt des Anschlags vorgespannt. Der konstruktive Aufbau des Kontaktaufbrechmittels 80 entspricht dabei dem in der FIG 10.

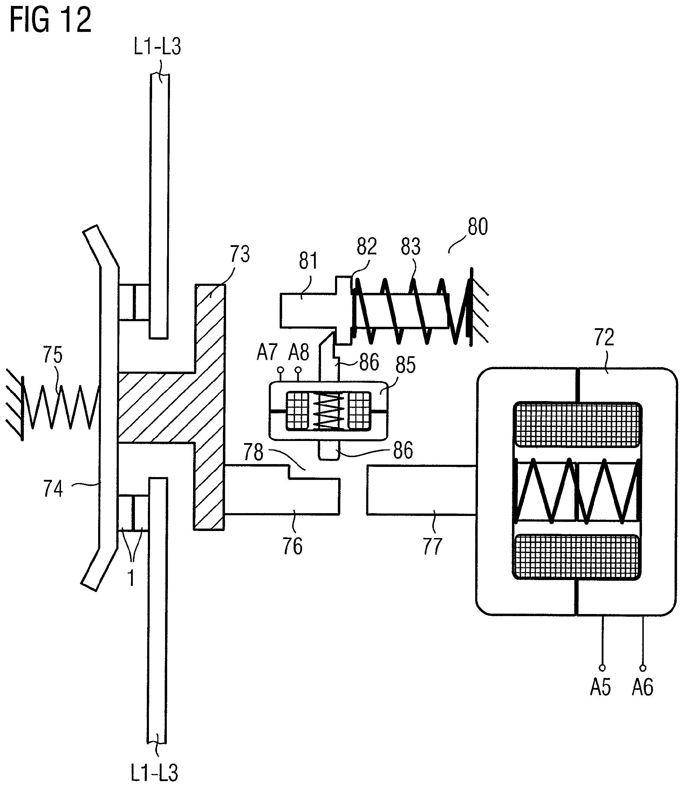

FIG 12 zeigt die siebte Ausführungsform der erfindungsgemäßen Vorrichtung mit geschlossenen Hauptkontakten 1. Dabei wird die Erregerspule des Steuermagneten 72 über die elektrischen Anschlüsse A5, A6 stromerregt. Der Anker 77 bewegt sich im Beispiel der FIG 12 nach rechts und entlastet den Kontaktschieber 73. Durch diese Entlastung und durch die Entspannung der vorgespannten Kontaktlastfeder 75 schließt nun die Kontaktbrücke 74 die Hauptkontakte 1.

Gemäß der Erfindung wird beim Einschalten das Freigabemittel 85 für das Kontaktaufbrechmittel 80 und gleichzeitig bzw. wenige Zeit danach der Steuermagnet 72 erregt. Dadurch bleibt die Rückstellfeder des Freigabemittels 85 weiterhin und nun aktiv vorgespannt. Im Vergleich zu FIG 11 ist zu erkennen, dass die Rückstellfeder des Aktors 85 sogar noch ein Stück mehr vorgespannt wird. Die Betätigungsverzögerung des Steuermagneten 72 gegenüber dem Freigabemittel 85 kann z.B. durch mechanische Dämpfungsmittel erfolgen, die nur für den Einschaltvorgang wirken. Alternativ können auch elektrische Dämpfungsmittel im Erregerkreis des Steuermagneten 72 eingesetzt werden, wie z. B. eine in Reihe zur Erregerspule des Steuermagneten 72 geschaltete Drossel. Der Aktoranker 86 gibt nun das Kontaktaufbrechmittel 80 nicht frei, obwohl durch die nun einsetzende Betätigung der Anker 77 des Steuermagneten 72 die Anschlag- bzw. Rückhaltefunktion freigibt.

Wie die FIG 12 zeigt, würde sich nun bei einer von außen erzwungenen Stromentregung der Aktoranker 86 durch die vorgespannte Rückstellfeder gemäß dem Beispiel der FIG 12 nach unten bewegen und dadurch das Kontaktaufbrechmittel 80 freigeben. Der besondere Vorteil dabei ist, dass die Auslösung des Kontaktaufbrechmittels 80 sicher erfolgt, da keine Energie zur Auslösung gepuffert oder kontinuierlich bereitgestellt werden muss. Die zur Auslösung benötigte Energie steckt in der bereits vorgespannten Rückstellfeder des Aktors 85. Der in der FIG 12 gezeigte Freigabe- und Kontaktaufbrechmechanismus ist somit "fail safe" ausgeführt.

Wie die FIG 12 weiterhin zeigt, entsteht aufgrund der Betätigung des Ankers 77 zum Verbindungsstück 76 eine Lücke von einigen Millimetern, die sich aufgrund des Neuzustands der Schaltkontakte 1 einstellt. Diese Lücke reduziert sich mit dem Verschleiß des Kontaktmaterials. Im EIN-Zustand liegt nun dem Ende des Aktorankers 86, welches dem Sperrzahn gegenüber liegt, das Verbindungsstück 76 gegenüber. Das Verbindungsstück 76 weist beispielhaft im Bereich des Aktorankers 86 eine Aussparung 78 auf, unabhängig davon, ob die Hauptkontakte 1 neu oder bereits verschlissen sind. Die Aussparung 78 ist so bemessen, dass bei Abfall des Freigabemittels 86, d.h. des als Hub- oder Tauchmagnet ausgebildeten Aktors, das Kontaktaufbrechmittel 80 sicher freigegeben wird. Alternativ könnte auch das Verbindungsstück 76 über seine gesamte Länge einen konstanten Querschnitt entsprechend den Abmessungen des Verbindungsstücks 76 im Endbereich aufweisen.

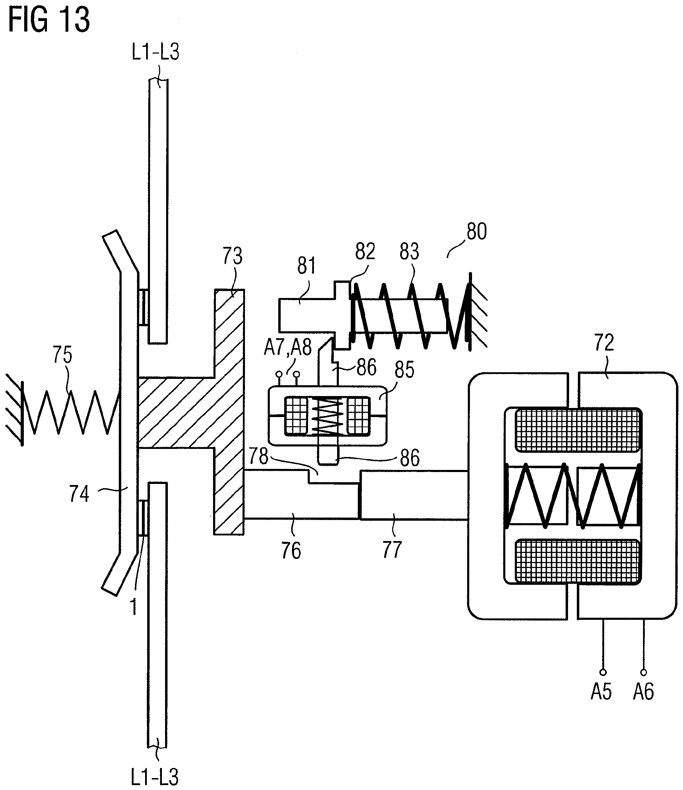

FIG 13 zeigt die siebte Ausführungsform der erfindungsgemäßen Vorrichtung mit einem verschweißten Hauptkontakt 1 mit noch nicht freigegebenem Kontaktaufbrechmittel 80. Das Ausschalten des Steuergerätes erfolgt üblicherweise dadurch, dass die Schaltspannung an den Klemmen A5 und A6 des Steuermagneten 72 unterbrochen bzw. weggenommen wird. Vorzugsweise speist die Schaltspannung auch das Freigabemittel 85 über die Klemmen A7 und A8, so dass nach Wegnahme der Schaltspannung auch dieses abfällt. Die Erregerkreise des Steuermagneten 72 und des Freigabemittels 85 können auch in Reihe geschaltet sein.

Erfindungsgemäß erkennt bzw. überprüft nun das Schaltgerät, ob die bewegliche Kontaktbrücke 74 des zumindest einen Hauptkontaktes 1 nach dem Ausschalten einen Öffnungspunkt überschritten hat. Wie die FIG 13 zeigt, öffnen sich nun die Hauptkontakte 1 aufgrund einer Verschweißung nicht mehr, so dass auch nach einer vorgegebenen Zeitdauer ein Öffnungspunkt nicht überschritten wird. Die vorgegebene Zeitdauer kann z.B. 100 ms betragen. Vorzugsweise fällt das Freigabemittel 85 beim Abschalten gegenüber dem Steuermagneten 72 verzögert ab, so dass der Anker 77 wieder beim Ausschalten die Anschlag- und Rückhaltefunktion für den Aktoranker 86 einnehmen kann. Der weitere Betrieb des Schaltgerätes wird nach Ablauf der vorgegebenen Zeitdauer dann unterbrochen, wenn sich der Anker 77 aufgrund eines verschweißten Hauptkontakts 1 nicht mehr betätigen lässt, so dass er den bereits abfallenden Aktoranker 86 noch "abfangen" könnte. Das Freigabemittel 85 fällt nun gänzlich ab und gibt dadurch das Kontaktaufbrechmittel 80 frei.

Die Abfallverzögerung beim Ausschalten des Aktors 85 kann z.B. mittels mechanischer Dämpfungssysteme oder mittels eines elektrischen Freilaufkreises mit einer Freilaufdiode im Erregerkreis des Aktors 85 erfolgen. Dabei hält der Freilaufkreis die Magnetisierung des magnetischen Kreises des Aktors 85 noch für die vorgegebene Zeitdauer aufrecht. Dagegen kann beim Ausschalten der Erregerkreis des Steuermagneten 72 elektrisch mittels eines relativ hochohmigen Widerstands bedämpft werden, so dass sehr schnell die magnetische Energie im magnetischen Kreis des Steuermagneten 72 abgebaut werden kann.

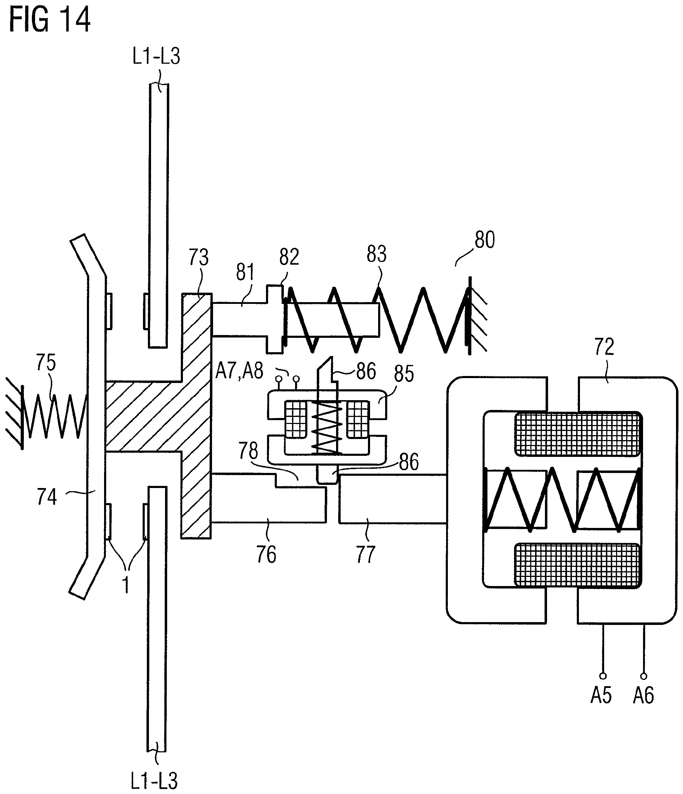

FIG 14 zeigt die siebte Ausführungsform der erfindungsgemäßen Vorrichtung mit dem mittels des freigegebenen Kontaktaufbrechmittels aufgebrochenem Hauptkontakt 1. Wie zuvor beschrieben, ist die Federkraft der Feder des Kontaktaufbrechmittels 80 so bemessen, dass diese neben der erforderlichen Aufbrechkraft auf die entgegengerichtete Federkraft der Kontaktlastfeder 75 überwinden kann. Ein Wiederschließen der Hauptkontakte 1 ist dadurch nicht mehr möglich. Der Betrieb des Schaltgerätes bleibt somit unterbrochen. Das Kontaktaufbrechmittel 80 kann auch eine nicht dargestellte Mechanik aufweisen, die es erlaubt, die ausgelöste Feder 83 sowie das Freigabemittel 85 wieder zu spannen. Dieses Zurücksetzen der Mechanik kann z.B. manuell erfolgen.

## Patentansprüche

1. Verfahren zum sicheren Betrieb eines Schaltgerätes mit zumindest einem ein- und ausschaltbaren Hauptkontakt, der Kontaktstücke und eine bewegliche Kontaktbrücke aufweist, und mit zumindest einem Steuermagneten, der einen beweglichen Anker aufweist, wobei der Anker beim Ein- und Ausschalten so auf die Kontaktbrücke wirkt, dass der entsprechende Hauptkontakt geschlossen und geöffnet wird,
mit den Schritten:

   a) Erkennen, ob die bewegliche Kontaktbrücke des zumindest einen Hauptkontaktes nach dem Ausschalten einen Öffnungspunkt überschritten hat, **gekennzeichnet durch** eine
   b) Unterbrechung des weiteren Betriebs des Schaltgerätes und Aktivieren eines Kontaktaufbrechmittels (46; 80), wenn nach einer vorgegebenen Zeitdauer der Öffnungspunkt nicht überschritten ist.

2. Verfahren nach Anspruch 1, **dadurch gekennzeichnet, dass** das Überschreiten des Öffnungspunktes durch eine Messung eines Stroms, in einer vom Hauptkontakt zu schaltenden Strombahn, erkannt wird, wobei der Öffnungspunkt nicht überschritten ist, wenn der gemessene Strom größer als ein nach dem Ausschalten vorgesehener Strom ist.

3. Verfahren nach Anspruch 1, **dadurch gekennzeichnet, dass** das Überschreiten des Öffnungspunktes durch eine Messung eines Spannungsabfalls über einen Hauptkontakt erkannt wird, wobei der Öffnungspunkt nicht überschritten ist, wenn der Spannungsabfall kleiner als ein nach dem Ausschalten vorgesehener Spannungsabfall ist.

4. Verfahren nach Anspruch 1, **dadurch gekennzeichnet, dass** das Überschreiten des Öffnungspunktes durch eine Messung einer Induktivität des Steuermagneten erkannt wird, wobei der Öffnungspunkt nicht überschritten ist, wenn die Induktivität nach dem Ausschalten einen Wert aufweist, der nicht dem vorgegebenen Wert nach dem Öffnen entspricht.

5. Verfahren nach Anspruch 1, **dadurch gekennzeichnet, dass** der Öffnungspunkt durch einen Zustand von mit der Kontaktbrücke in Wirkverbindung stehenden Mitteln erkannt wird, wobei der erkannte Öffnungspunkt nicht überschritten ist, wenn diese Mittel nach dem Ausschalten in diesem Zustand verbleiben, der nicht dem vorgegebenen Zustand nach dem Öffnen entspricht.

6. Verfahren nach Anspruch 5, **dadurch gekennzeichnet,**

   - **dass** beim Einschalten oder zum Einschalten eines Steuermagneten (42) ein Hilfskontakt (45) geschlossen wird,
   - **dass** beim Einschalten des Steuermagneten (42) ein Öffnerkontakt (41) geöffnet wird, und
   - **dass** ein Freigabemittel (44), welches in Reihe zu den Schaltkontakten (41,45) geschaltet ist, das Kontaktaufbrechmittel (46) auslöst, wenn der Hilfskontakt (45) beim Ausschalten im geschlossenen Zustand verbleibt bzw. verblieben ist.

7. Verfahren nach Anspruch 6, **dadurch gekennzeichnet, dass** die Schaltkontakte (41, 45) so ausgeführt sind, dass der Hilfskontakt (45) beim Einschalten schließt, nachdem der Öffnerkontakt (41) geöffnet hat, und dass der Öffnerkontakt (41) beim Ausschalten schließt, nachdem der Hilfskontakt (45) geöffnet hat.

8. Verfahren nach Anspruch 5, **dadurch gekennzeichnet,**

   - **dass** beim Einschalten oder zum Einschalten eines Steuermagneten (42) ein Hilfskontakt geöffnet wird,

- **dass** beim Einschalten des Steuermagneten (42) ein Schließerkontakt geschlossen wird, und
- **dass** ein Freigabemittel das Kontaktaufbrechmittel (46) auslöst, wenn der Hilfskontakt beim Ausschalten im geöffneten Zustand verbleibt bzw. verblieben ist, indem der jeweils geöffnete Schaltzustand der besagten Schaltkontakte ausgewertet wird.

9. Verfahren nach Anspruch 8, **dadurch gekennzeichnet, dass** die besagten Schaltkontakte so ausgeführt sind, dass der Hilfskontakt beim Einschalten öffnet, nachdem der Schließerkontakt geschlossen hat, und dass der Schließerkontakt beim Ausschalten öffnet, nachdem der Hilfskontakt geschlossen hat.

10. Verfahren nach Anspruch 1, **dadurch gekennzeichnet, dass** bei einer Schaltbetätigung eine magnetische Flussänderung des magnetischen Kreises des Steuermagneten (60) gemessen wird, wobei der Öffnungspunkt überschritten ist, wenn beim Ausschalten des Steuermagneten (60) die magnetische Flussänderung einen vorgegebenen Vergleichswert überschritten hat.

11. Verfahren nach Anspruch 10, **dadurch gekenn-zeichnet**, dass die magnetische Flussänderung mittels einer Induktionsspule (62) gemessen wird.

12. Verfahren nach Anspruch 1, **dadurch gekennzeichnet, dass** die elektrische Versorgung für eine Auswerte- und Steuereinheit (91) des Schaltgerätes mittels eines elektrischen Speicherelements (94) für eine Mindestzeit aufrechterhalten wird, um ein Vorliegen eines verschweißten Hauptkontakts (1) messtechnisch zu erkennen und um ggf. das Kontaktaufbrechmittel (80) und/oder ein Schaltschloss anzusteuern bzw. freizugeben.

13. Verfahren nach Anspruch 12, **dadurch gekennzeichnet, dass** der Steuermagnet (92) bei Vorliegen eines Schaltbefehls erst dann zum Betätigen zumindest eines Hauptkontakts (1) erregt wird, wenn das elektrische Speicherelement (94) einen Mindestladezustand erreicht hat.

14. Verfahren nach Anspruch 1, **dadurch gekenn zeichnet**,

- dass im eingeschalteten Zustand des Steuermagneten (72) aktiv ein Freigabemittel (95) in einem erregten Zustand gehalten wird, um die Auslösung des Kontaktaufbrechmittels (80) zu verhindern, und
- dass beim Ausschalten das Freigabemittel (85) und der Steuermagnet (72) entregt werden, wobei dann ein Anker (77) oder eine mit dem Anker (77) in einer mechanischen Wirkverbindung stehende Komponente des Steuermagneten (72) die Auslösung des Freigabemittels (85) verhindert.

15. Verfahren nach Anspruch 14, **dadurch gekennzeichnet, dass** beim Einschalten das Freigabemittel (85) vor dem Steuermagneten (72) erregt wird und dass beim Ausschalten der Steuermagnet (72) vor dem Freigabemittel (85) entregt wird.

16. Verfahren nach Anspruch 14 oder 15, **dadurch gekennzeichnet, dass** das Freigabemittel (85) ein Hub- oder Tauchmagnet ist.

17. Verfahren nach einem der Ansprüche 14 bis 16, **dadurch gekennzeichnet , dass** das Kontaktaufbrechmittel (80) einen Federspeicher aufweist.

18. Verfahren nach einem der vorangegangenen Ansprüche, **dadurch gekennzeichnet, dass** der weitere Betrieb unterbrochen wird, indem ein in Reihe mit dem Hauptkontakt (1) in der Strombahn (L1-L3) angeordnetes Schaltelement geöffnet wird.

19. Verfahren nach einem der vorangegangenen Ansprüche, **dadurch gekennzeichnet, dass** der weitere Betrieb unterbrochen wird, indem zumindest eine Steuerleitung zum Steuern des Steuermagneten unterbrochen wird.

20. Vorrichtung zum sicheren Betrieb eines Schaltgerätes, wobei das Schaltgerät zumindest einen ein- und ausschaltbaren Hauptkontakt, der Kontaktstücke und eine bewegliche Kontaktbrücke aufweist, und zumindest einen Steuermagneten, der einen beweglichen Anker aufweist, umfasst, und wobei der Anker beim Ein- und Ausschalten so auf die Kontaktbrücke wirkt, dass der entsprechende Hauptkontakt schließbar und offenbar ist, mit

- ersten Mittel zum Erkennen, ob ein Öffnungspunkt der Kontaktbrücke des zumindest einen Hauptkontaktes überschritten wurde,

**gekennzeichnet durch** weiteren Mitteln, die den weiteren Betrieb des Schaltgerätes unterbrechen und ein Kontaktaufbrechmittel (46; 80) aktivieren, wenn die Mittel nach dem Ausschalten erkennen, dass der Öffnungspunkt nach einer vorgegebenen Zeitdauer nicht überschritten ist.

21. Vorrichtung nach Anspruch 20, **dadurch gekennzeichnet, dass** die ersten Mittel einen Stromsensor umfassen, der den Strom in einer vom Hauptkontakt zu schaltenden Strombahn misst.

22. Vorrichtung nach Anspruch 20, **dadurch gekennzeichnet, dass** die ersten Mittel zwei Elektroden umfassen, wobei die erste und die zweite Elektrode so angeordnet sind, dass ein Spannungsabfall über den Hauptkontakt ableitbar ist.

23. Vorrichtung nach Anspruch 20, **dadurch gekennzeichnet, dass** die ersten Mittel, ein Mittel zum Detektieren einer Induktivität umfassen, das die Induktivität des Steuermagneten misst.

24. Vorrichtung nach Anspruch 20, **dadurch gekennzeichnet, dass** die ersten Mittel eine Öffnungsmechanik umfassen, die in Wirkverbindung mit der Kontaktbrücke steht und einen ersten und zweiten Zustand einnehmen kann.

25. Vorrichtung nach Anspruch 24, **dadurch gekennzeichnet, dass**

- dass ein Hilfskontakt (45) vorgesehen ist, der sich beim Einschalten des Steuermagneten (42) schließt bzw. der zum Einschalten des Steuermagneten (42) geschlossen wird,
- dass ein Öffnerkontakt (41) vorgesehen und so ausgebildet ist, dass dieser beim Einschalten des Steuermagneten (42) geöffnet wird, und
- dass ein Freigabemittel (44) vorgesehen ist, welches in Reihe zu den Schaltkontakten (41, 45) geschaltet ist und welches das Kontaktaufbrechmittel (46) auslöst, wenn der Hilfskontakt (45) beim Ausschalten im geschlossenen Zustand verbleibt bzw. verblieben ist.

26. Vorrichtung nach Anspruch 25, **dadurch gekennzeichnet, dass** die Schaltkontakte (41,45) so ausgeführt sind, dass der Hilfskontakt (45) beim Einschalten schließt, nachdem der Öffnerkontakt (41) geöffnet hat, und dass der Öffnerkontakt (41) beim Ausschalten schließt, nachdem der Hilfskontakt (45) geöffnet hat.

27. Vorrichtung nach Anspruch 24, **dadurch gekennzeichnet,**

- **dass** ein Hilfskontakt vorgesehen ist, der sich beim Einschalten des Steuermagneten (42) öffnet bzw. der zum Einschalten des Steuermagneten (42) geöffnet wird,
- **dass** ein Schließerkontakt vorgesehen und so ausgebildet ist, dass dieser beim Einschalten des Steuermagneten (42) geschlossen wird, und
- **dass** ein Freigabemittel vorgesehen ist, welches das Kontaktaufbrechmittel (46) auslöst, wenn der Hilfskontakt beim Ausschalten im geöffneten Zustand verbleibt bzw. verblieben ist, indem Auswertemittel den jeweils geöffneten Schaltzustand der besagten Schaltkontakte auswerten.

28. Vorrichtung nach Anspruch 27, **dadurch gekennzeichnet, dass** die Schaltkontakte so ausgeführt sind, dass der Hilfskontakt beim Einschalten öffnet, nachdem der Schließerkontakt geschlossen hat, und dass der Schließerkontakt beim Ausschalten öffnet, nachdem der Hilfskontakt geschlossen hat.

29. Vorrichtung nach Anspruch 20, **dadurch gekennzeichnet, dass** ein Mittel zum Erfassen einer magnetischen Flussänderung des magnetischen Kreis des Steuermagneten (60) bei einer Schaltbetätigung vorgesehen ist, wobei der Öffnungspunkt überschritten ist, wenn beim Ausschalten des Steuermagneten (60) die magnetische Flussänderung einen vorgegebenen Vergleichswert überschritten hat.

30. Vorrichtung nach Anspruch 29, **dadurch gekennzeichnet, dass** die magnetische Flussänderung mittels einer Induktionsspule (62) messbar ist.

31. Vorrichtung nach Anspruch 20, **dadurch gekennzeichnet, dass** ein elektrisches Speicherelement (94) zur Aufrechterhaltung der elektrischen Versorgung für eine Auswerte- und Steuereinheit (91) des Schaltgerätes für eine Mindestzeit vorgesehen ist, um ein Vorliegen eines verschweißten Hauptkontakts (1) messtechnisch zu erkennen und um ggf. das Kontaktaufbrechmittel (80) und/oder ein Schaltschloss anzusteuern bzw. freizugeben.

**32.** Vorrichtung nach Anspruch 31, **dadurch gekennzeichnet, dass** Mittel (91) vorgesehen sind, die den Steuermagneten (92) bei Vorliegen eines Schaltbefehls erst dann zum Betätigen zumindest eines Hauptkontakts (1) erregen, wenn das elektrische Speicherelement (94) einen Mindestladezustand erreicht hat.

**33.** Vorrichtung nach Anspruch 20, **dadurch gekennzeichnet,**

- **dass** ein Freigabemittel (85) vorgesehen ist, welches im eingeschalteten Zustand des Steuermagneten (72) aktiv in einem erregten Zustand gehalten wird, um die Auslösung des Kontaktaufbrechmittels (80) zu verhindern, und
- **dass** das Freigabemittel (85) sowie der Steuermagnet (72) beim Ausschalten entregt werden, wobei dann ein Anker (77) oder eine mit dem Anker (77) in einer mechanischen Wirkverbindung stehende Komponente des Steuermagneten (72) die Auslösung des Freigabemittels (85) verhindert.

**34.** Vorrichtung nach Anspruch 33, **dadurch gekennzeichnet, dass** Mittel vorgesehen sind, welche beim Einschalten das Freigabemittel (85) zeitlich vor dem Steuermagneten (72) entregen und welche beim Ausschalten den Steuermagneten (72) zeitlich vor dem Freigabemittel (85) entregen.

**35.** Vorrichtung nach Anspruch 33 oder 34, **dadurch gekennzeichnet, dass** das Freigabemittel (85) ein Hub- oder Tauchmagnet ist.

**36.** Vorrichtung nach einem der Ansprüche 33 bis 35, **dadurch gekennzeichnet, dass** das Kontaktaufbrechmittel (80) einen Federspeicher aufweist.

**37.** Vorrichtung nach einem der Ansprüche 20 bis 36, **dadurch gekennzeichnet, dass** die weiteren Mittel eine Auswerteeinrichtung umfassen, die zum Unterbrechen des weiteren Betriebs ein in Reihe mit dem Hauptkontakt in der Strombahn angeordnetes Schaltelement öffnet.

**38.** Vorrichtung nach einem der Ansprüche 20 bis 37, **dadurch gekennzeichnet, dass** die weiteren Mittel eine Steuereinrichtung zum Steuern des Steuermagneten umfassen, die zum Unterbrechen des weiteren Betriebs die Steuerleitung zum Steuermagneten unterbricht.

**39.** Schaltgerät das zum sicheren Schalten von Verbrauchern das Verfahren nach einem der Ansprüche 1 bis 19 durchführt, wobei das Schaltgerät ein Schütz oder ein Leistungsschalter oder ein Kompaktabzweig ist.

**40.** Schaltgerät zum sicheren Schalten von Verbrauchern mit einer Vorrichtung nach einem der Ansprüche 20 bis 38, wobei das Schaltgerät ein Schütz oder ein Leistungsschalter oder ein Kompaktabzweig ist.

**41.** Schaltgerät nach Anspruch 39 oder 40, **dadurch gekennzeichnet, dass** das Schaltgerät ein dreipoliges Schaltgerät mit drei Hauptkontakten zum Ein- und Ausschalten von drei Strombahnen mit einem Steuermagneten ist.

**Claims**

**1.** Method for safe operation of a switching device having at least one main contact which can be connected and disconnected and has contact pieces and a moving contact link, and having at least one control magnet which has a moving armature with the armature acting on the contact link during connection and disconnection such that the corresponding main contact is closed and opened,
having the following steps:

a) identification of whether the moving contact link of the at least one main contact has passed beyond an opening point after disconnection,
**characterized by**
b) interruption of further operation of the switching device and activation of a contact breaking-open means (46; 80) if the opening point has not been passed after a predetermined time period.

**2.** Method according to Claim 1, **characterized in that** the fact that the opening point has been passed is identified by measuring a current in a current path to be switched by the main contact, with the opening point not having been passed if the measured current is greater than the intended current after disconnection.

3. Method according to Claim 1, **characterized in that** the fact that the opening point has been passed is identified by measuring a voltage drop across a main contact, with the opening point not having been passed if the voltage drop is less than the intended voltage drop after disconnection.

4. Method according to Claim 1, **characterized in that** the fact that the opening point has been passed is identified by measuring an inductance of the control magnet, with the opening point not having been passed if the inductance after disconnection has a value which does not correspond to the intended value after opening.

5. Method according to Claim 1, **characterized in that** the opening point is identified by a state of means which are operatively connected to the contact link, with the identified opening point not having been passed if these means remain in this state, which does not correspond to the predetermined state after opening, after disconnection.

6. Method according to Claim 5, **characterized**

   - **in that** an auxiliary contact (45) is closed on connection or for connection of a control magnet (42),
   - **in that** a break contact (41) is opened on connection of the control magnet (42) and
   - a release means (44), which is connected in series with the switching contacts (41, 45) initiates the contact breaking-open means (46) if the auxiliary contact (45) remains, or has remained, in the closed state on disconnection.

7. Method according to Claim 6, **characterized in that** the switching contacts (41, 45) are designed such that, during connection, the auxiliary contact (45) closes after the break contact (41) has opened, and such that, during disconnection, the break contact (41) closes after the auxiliary contact (45) has opened.

8. Method according to Claim 5, **characterized**

   - **in that** an auxiliary contact is opened during connection or for connection of a control magnet (42),
   - **in that** a make contact is closed during connection of the control magnet (42)
   - such that a release means initiates the contact breaking-open means (46) if the auxiliary contact remains, or has remained, in the open state during disconnection, in that the respective opened switching state of the said switching contacts is evaluated.

9. Method according to Claim 8, **characterized in that** the said switching contacts are designed such that, during connection, the auxiliary contact opens after the make contact has closed, and such that, during disconnection, the make contact opens after the auxiliary contact has closed.

10. Method according to Claim 1, **characterized in that**, during a switching operation, any magnetic flux change in the magnetic circuit of the control magnet (60) is measured, with the opening point being passed over when, during disconnection of the control magnet (60), the magnetic flux change has exceeded a predetermined comparison value.

11. Method according to Claim 10, **characterized in that**, the magnetic flux change is measured by means of an induction coil (62) .

12. Method according to Claim 1, **characterized in that** the electrical supply for an evaluation and control unit (91) for the switching device is maintained by means of an electrical energy-storage element (94) for a minimum time, in order to identify by measurement the presence of a welded main contact (1) and in order, if necessary, to actuate or to release a contact-breaking open means (80) and/or a latching mechanism.

13. Method according to Claim 12, **characterized in that**, in the presence of a switching command, the control magnet (92) is energized to operate at least one main contact (1) only once the electrical-energy storage element (94) has reached a minimum state of charge.

14. Method according to Claim 1, **characterized**

   - **in that**, when the control magnet (72) is in the connected state, a release means (95) is actively held in an energized state in order to prevent the initiation of the contact breaking-open means (80), and
   - **in that**, during disconnection, the release means (85) and the control magnet (72) are de-energized with an armature (77) or a component of the control magnet (72) which is mechanically operatively connected to the armature (77), preventing the initiation of the release means (85).

15. Method according to Claim 14, **characterized in that**, during connection, the release means (85) is energized before the control magnet (72) and **in that**, during disconnection, the control magnet (72) is de-energized before the release means (85) .

16. Method according to Claim 14 or 15, **characterized in that** the release means (85) is a solenoid or a plunger-type magnet.

17. Method according to one of Claims 14 to 16, **characterized in that** the contact breaking-open means (80) has a spring energy store.

18. Method according to one of the preceding claims, **characterized in that** further operation is interrupted by opening a switching element which is arranged in series with the main contact (1) in the current path (L1-L3).

19. Method according to one of the preceding claims, **characterized in that** further operation is interrupted by interrupting at least one control line for controlling the control magnet.

20. Apparatus for safe operation of a switching device, with the switching device having at least one main contact which can be connected and disconnected, the contact pieces and the moving contact link, and comprising at least one control magnet, which has a moving armature, and with the armature acting on the contact link during connection and disconnection such that the corresponding main contact can be closed and opened, having

   - first means for identifying whether an opening point of the contact link of the at least one main contact has been passed,
   **characterized by**
   - further means which interrupt further operation of the switching device and activate a contact breaking-open means (46; 80) if, after disconnection, the means identify that the opening point has not been passed after a predetermined time period.

21. Apparatus according to Claim 20, **characterized in that** the first means comprise a current sensor which measures the current in a current path to be switched by the main contact.

22. Apparatus according to Claim 20, **characterized in that** the first means comprise two electrodes, with the first and the second electrode being arranged such that any voltage drop across the main contact can be dissipated.

23. Apparatus according to Claim 20, **characterized in that** the first means comprise a means for detection of an inductance that measures the inductance of the control magnet.

24. Apparatus according to Claim 20, **characterized in that** the first means comprise an opening mechanism which is operatively connected to the contact link and can assume a first and a second state.

25. Apparatus according to Claim 24, **characterized**

   - **in that** an auxiliary contact (45) is provided, which closes during connection of the control magnet (42) or is closed for connection of the control magnet (42),
   - **in that** a break contact (42) is provided and is designed such that it is opened on connection of the control magnet (42), and
   - **in that** a release means (44) is provided, which is connected in series with the switching contacts (41, 45) and initiates the contact breaking-open means (46) if the auxiliary contact (45) remains, or has remained in the closed state during disconnection.

26. Apparatus according to Claim 25, **characterized in that** the switching contacts (41, 45) are designed such that, during connection, the auxiliary contact (45) closes after the break contact (41) is opened, and such that, during disconnection, the break contact (41) closes after the auxiliary contact (45) has opened.

27. Apparatus according to Claim 24, **characterized**

- **in that** an auxiliary contact is provided, which opens on connection of the control magnet (42) or is opened for connection of the control magnet (42),
- **in that** a make contact is provided and is designed such that it is closed on connection of the control magnet (42), and
- **in that** a release means is provided, which initiates the contact breaking-open means (46) if the auxiliary contact remains, or has remained in the open state during disconnection, in that the evaluation means evaluate the respectively open switching state of the said switching contacts.

28. Apparatus according to Claim 27, **characterized in that** the switching contacts are designed such that, during connection, the auxiliary contact opens, after the make contact has closed and **in that** during disconnection, the make contact opens after the auxiliary contact has closed.

29. Apparatus according to Claim 20, **characterized in that** a means is provided for detecting any magnetic flux change in the magnetic circuit of the control magnet (60) during a switching operation with the opening point having been passed when the magnetic flux change has exceeded a predetermined comparison value on disconnection of the control magnet (60).

30. Apparatus according to Claim 29, **characterized in that** the magnetic flux change can be measured by means of an induction coil (62).

31. Apparatus according to Claim 20, **characterized in that** an electrical energy-storage element (94) is provided to maintain the electrical supply for an evaluation and control unit (91) for the switching device for a minimum time, in order to detect, by measurement, the presence of a welded main contact (1) and, if required to actuate or to release a contact breaking-open means (80) and/or a latching mechanism.

32. Apparatus according to Claim 31, **characterized in that** means (91) are provided to energize the control magnet (92) when a switching command has occurred for operation of at least one main contact (1) only when the electrical energy-storage element (94) has reached a minimum state of charge.

33. Apparatus according to Claim 20, **characterized**

   - **in that** a release means (85) is provided which is actively held in an energized state when the control magnet (72) is in the connected state, in order to prevent initiation of the contact breaking-open means (80) and
   - **in that** the release means (85) and the control magnet (72) are de-energized during disconnection, with an armature (77) or a component of the control magnet (72) which is mechanically operatively connected to the armature (77) preventing the initiation of the release means (85) in this case.

34. Apparatus according to Claim 33, **characterized in that** means are provided which de-energize the release means (85) at a time before de-energizing of the control magnet (72) during connection and which de-energize the control magnet (72) at a time before the release means (85) is de-energized, during disconnection.

35. Apparatus according to Claim 33 or 34, **characterized in that** the release means (85) is a solenoid or plunger-type magnet.

36. Apparatus according to one of Claims 33 to 35, **characterized in that** the contact breaking-open means (80) has a spring energy store.

37. Apparatus according to one of Claims 20 to 36, **characterized in that** the further means comprise an evaluation device which opens a switching element, which is arranged in series with the main contact in the current path, in order to interrupt further operation.

38. Apparatus according to one of Claims 20 to 37, **characterized in that** the further means comprise a control device for controlling the control magnet, which control device interrupts the control line to the control magnet in order to interrupt further operation.

39. Switching device which carries out the method according to one of Claims 1 to 19 for safe switching of loads, with the switching device being a contactor, a circuit breaker or a compact outgoer.

40. Switching device for safe switching of loads having an apparatus according to one of Claims 20 to 38, with the switching device being a contactor, a circuit breaker or a compact outgoer.

41. Switching device according to Claim 39 or 40, **characterized in that** the switching device is a three-pole switching device having three main contacts for connection and disconnection of three current paths with a control magnet.

**Revendications**

1. Procédé pour le fonctionnement sûr d'un appareil de commutation comportant au moins un contact principal pouvant être enclenché et coupé et qui comporte des pièces de contact et un pont de contact mobile, et au moins un aimant de commande qui comporte un induit mobile, l'induit agissant de manière telle sur le pont de contact, à l'enclenchement et à la coupure, que le contact principal correspondant s'ouvre et se ferme, comportant les étapes suivantes :

   a) reconnaître si le pont de contact mobile de l'au moins un contact principal a dépassé un point d'ouverture après la coupure,
   **caractérisé par** une
   b) interruption de la poursuite du fonctionnement de l'appareil de commutation et activation d'un moyen de forçage du contact en ouverture (46 ; 80) si le point d'ouverture n'est pas dépassé après une durée de temps spécifiée.

2. Procédé selon la revendication 1, **caractérisé en ce que** le dépassement du point d'ouverture est reconnu par une mesure d'un courant dans une voie de passage du courant à commuter par le contact principal, le point d'ouverture n'étant pas dépassé si le courant mesuré est supérieur à un courant prévu après la coupure.

3. Procédé selon la revendication 1, **caractérisé en ce que** le dépassement du point d'ouverture est reconnu par une mesure d'une chute de tension via un contact principal, le point d'ouverture n'étant pas dépassé si la chute de tension est inférieure à une chute de tension prévue après la coupure.

4. Procédé selon la revendication 1, **caractérisé en ce que** le dépassement du point d'ouverture est reconnu par une mesure d'une inductance de l'aimant de commande, le point d'ouverture n'étant pas dépassé si l'inductance présente, après la coupure, une valeur qui ne correspond pas à la valeur spécifiée après l'ouverture.

5. Procédé selon la revendication 1, **caractérisé en ce que** le point d'ouverture est reconnu par un état de moyens en liaison active avec le pont de contact, le point d'ouverture reconnu n'étant pas dépassé si ces moyens restent, après la coupure, dans cet état qui ne correspond pas à l'état spécifié après la coupure.

6. Procédé selon la revendication 5, **caractérisé en ce que** :

   - un contact auxiliaire (45) se ferme à l'enclenchement ou pour l'enclenchement d'un aimant de commande (42) ;
   - un contact d'ouverture (41) s'ouvre à l'enclenchement de l'aimant de commande (42) et
   - un moyen de libération (44) monté en série avec les contacts de commutation (41, 45) et qui déclenche le moyen de forçage du contact en ouverture (46) si le contact auxiliaire (45) reste resp. est resté à l'état fermé à la coupure.

7. Procédé selon la revendication 6, **caractérisé en ce que** les contacts de commutation (41, 45) sont réalisés de telle sorte que le contact auxiliaire (45) se ferme à l'enclenchement après que le contact d'ouverture (41) s'est ouvert et **en ce que** le contact d'ouverture (41) se ferme à la coupure après que le contact auxiliaire (45) s'est ouvert.

8. Procédé selon la revendication 5, **caractérisé en ce que** :

   - un contact auxiliaire s'ouvre à l'enclenchement ou pour l'enclenchement d'un aimant de commande (42) ;
   - un contact de fermeture se ferme à l'enclenchement de l'aimant de commande (42) et
   - un moyen de libération déclenche le moyen de forçage du contact en ouverture (46) si le contact auxiliaire reste resp. est resté à l'état ouvert à la coupure par évaluation de l'état de commutation respectivement ouvert desdits contacts de commutation.

**9.** Procédé selon la revendication 8, **caractérisé en ce que** lesdits contacts de commutation sont réalisés de telle sorte que le contact auxiliaire s'ouvre à l'enclenchement après que le contact de fermeture s'est fermé et **en ce que** le contact de fermeture s'ouvre à la coupure après que le contact auxiliaire s'est fermé.

**10.** Procédé selon la revendication 1, **caractérisé en ce qu'**une modification du flux magnétique du circuit magnétique de l'aimant de commande (60) est mesurée lors d'une commande de commutation, le point d'ouverture étant dépassé si, à la coupure de l'aimant de commande (60), la modification du flux magnétique a dépassé une valeur de comparaison spécifiée.

**11.** Procédé selon la revendication 10, **caractérisé en ce que** la modification du flux magnétique est mesurée au moyen d'une bobine d'induction (62).

**12.** Procédé selon la revendication 1, **caractérisé en ce que** l'alimentation électrique pour une unité d'évaluation et de commande (91) de l'appareil de commutation est maintenue au moyen d'un élément d'accumulation électrique (94) pour un temps minimum pour reconnaître, par une technique de mesure, une présence d'un contact principal soudé (1) et pour commander resp. libérer, le cas échéant, le moyen de forçage du contact en ouverture (80) et/ou un verrou de commutation.

**13.** Procédé selon la revendication 12, **caractérisé en ce que** l'aimant de commande (92), en présence d'un ordre de commutation, n'est excité pour actionner au moins un contact principal (1) que si l'élément d'accumulation électrique (94) a atteint un état de charge minimum.

**14.** Procédé selon la revendication 1, **caractérisé en ce que**

- à l'état enclenché de l'aimant de commande (72), un moyen de libération (95) est maintenu activement dans un état excité pour empêcher le déclenchement du moyen de forçage du contact en ouverture (80) et
- à la coupure, le moyen de libération (85) et l'aimant de commande (72) sont désexcités, un induit (77) ou un composant de l'aimant de commande (72) en liaison mécanique active avec l'induit (77) empêchant alors le déclenchement du moyen de libération (85).

**15.** Procédé selon la revendication 14, **caractérisé en ce que**, à l'enclenchement, le moyen de libération (85) est excité avant l'aimant de commande (72) et **en ce que**, à la coupure, l'aimant de commande (72) est désexcité avant le moyen de libération (85).

**16.** Procédé selon la revendication 14 ou 15, **caractérisé en ce que** le moyen de libération (85) est un aimant de levage ou un aimant plongeant.

**17.** Procédé selon l'une des revendications 14 à 16, **caractérisé en ce que** le moyen de forçage du contact en ouverture (80) comporte un accumulateur à ressort.

**18.** Procédé selon l'une des revendications précédentes, **caractérisé en ce que** la poursuite du fonctionnement est interrompue par ouverture d'un élément de commutation monté en série avec le contact principal (1) dans la voie de passage du courant (L1-L3).

**19.** Procédé selon l'une des revendications précédentes, **caractérisé en ce que** la poursuite du fonctionnement est interrompue par interruption d'au moins une ligne de commande pour la commande de l'aimant de commande.

**20.** Dispositif pour le fonctionnement sûr d'un appareil de commutation, l'appareil de commutation comprenant au moins un contact principal pouvant être enclenché et coupé et comportant des pièces de contact et un pont de contact mobile, et au moins un aimant de commande comportant un induit mobile, et l'induit, à l'enclenchement et à la coupure, agissant de manière telle sur le pont de contact que le contact principal correspondant peut se fermer et s'ouvrir, avec :

- des premiers moyens pour reconnaître si un point d'ouverture du pont de contact de l'au moins un contact principal a été dépassé,

**caractérisé par**
d'autres moyens qui interrompent la poursuite du fonctionnement de l'appareil de commutation et activent un moyen de forçage du contact en ouverture (46 ; 80) lorsque les moyens, après la coupure, reconnaissent que le point d'ouverture n'est pas dépassé après une durée de temps spécifiée.

21. Dispositif selon la revendication 20, **caractérisé en ce que** les premiers moyens comprennent un capteur de courant qui mesure le courant dans une voie de passage du courant à commuter par le contact principal.

22. Dispositif selon la revendication 20, **caractérisé en ce que** les premiers moyens comprennent deux électrodes, la première et la deuxième électrode étant agencées de telle sorte qu'il est possible de déduire une chute de tension via le contact principal.

23. Dispositif selon la revendication 20, **caractérisé en ce que** les premiers moyens comprennent un moyen de détection d'une inductance qui mesure l'inductance de l'aimant de commande.

24. Dispositif selon la revendication 20, **caractérisé en ce que** les premiers moyens comprennent une mécanique d'ouverture qui est en liaison active avec le pont de contact et peut se mettre dans un premier et un deuxième état.

25. Dispositif selon la revendication 24, **caractérisé en ce que** :

- il est prévu un contact auxiliaire (45) qui se ferme à l'enclenchement de l'aimant de commande (42) resp. qui se ferme pour l'enclenchement de l'aimant de commande (42) ;
- un contact d'ouverture (41) est prévu et est réalisé de telle sorte que celui-ci s'ouvre à l'enclenchement de l'aimant de commande (42) et
- il est prévu un moyen de libération (44) qui est monté en série avec les contacts de commutation (41, 45) et qui déclenche le moyen de forçage du contact en ouverture (46) lorsque le contact auxiliaire (45), à la coupure, reste resp. est resté à l'état fermé.

26. Dispositif selon la revendication 25, **caractérisé en ce que** les contacts de commutation (41,45) sont réalisés de telle sorte que le contact auxiliaire (45) se ferme à l'enclenchement après que le contact d'ouverture (41) s'est ouvert et **en ce que** le contact d'ouverture (41) se ferme à la coupure après que le contact auxiliaire (45) s'est ouvert.

27. Dispositif selon la revendication 24, **caractérisé en ce que** :

- il est prévu un contact auxiliaire qui s'ouvre à l'enclenchement de l'aimant de commande (42) resp. qui s'ouvre pour l'enclenchement de l'aimant de commande (42) ;
- un contact de fermeture est prévu et est réalisé de telle sorte que celui-ci se ferme à l'enclenchement de l'aimant de commande (42) et
- il est prévu un moyen de libération qui déclenche le moyen de forçage du contact en ouverture (46), lorsque le contact auxiliaire, à la coupure, reste resp. est resté à l'état ouvert, par évaluation, par des moyens d'évaluation, de l'état de commutation respectivement ouvert desdits contacts de commutation.

28. Dispositif selon la revendication 27, **caractérisé en ce que** les contacts de commutation sont réalisés de telle sorte que le contact auxiliaire s'ouvre à l'enclenchement après que le contact de fermeture s'est fermé et **en ce que** le contact de fermeture s'ouvre à la coupure après que le contact auxiliaire s'est fermé.

29. Dispositif selon la revendication 20, **caractérisé en ce qu'**est prévu un moyen de détection d'une modification du flux magnétique du circuit magnétique de l'aimant de commande (60) en cas de commande de commutation, le point d'ouverture étant dépassé si, à la coupure de l'aimant de commande (60), la modification du flux magnétique a dépassé une valeur de comparaison spécifiée.

30. Dispositif selon la revendication 29, **caractérisé en ce que** la modification du flux magnétique peut être mesurée au moyen d'une bobine d'induction (62).

31. Dispositif selon la revendication 20, **caractérisé en ce qu'**est prévu un élément d'accumulation électrique (94) pour maintenir l'alimentation électrique pour une unité d'évaluation et de commande (91) de l'appareil de commutation pour un temps minimum pour reconnaître, par une technique de mesure, une présence d'un contact principal soudé (1) et pour commander resp. libérer, le cas échéant, le moyen de forçage du contact en ouverture (80) et/ou un verrou de commutation.

**32.** Dispositif selon la revendication 31, **caractérisé en ce que** sont prévus des moyens (91) qui, en présence d'un ordre de commutation, n'excitent l'aimant de commande (92) pour actionner au moins un contact principal (1) que si l'élément d'accumulation électrique (94) a atteint un état de charge minimum.

**33.** Dispositif selon la revendication 20, **caractérisé en ce que** :

- il est prévu un moyen de libération (85) qui, à l'état enclenché de l'aimant de commande (72), est maintenu activement dans un état excité pour empêcher le déclenchement du moyen de forçage du contact en ouverture (80) et
- à la coupure, le moyen de libération (85) et l'aimant de commande (72) sont désexcités, un induit (77) ou un composant de l'aimant de commande (72) en liaison mécanique active avec l'induit (77) empêchant alors le déclenchement du moyen de libération (85).

**34.** Dispositif selon la revendication 33, **caractérisé en ce que** sont prévus des moyens qui, à l'enclenchement, désexcitent le moyen de libération (85) avant l'aimant de commande (72) dans le temps et qui, à la coupure, désexcitent l'aimant de commande (72) avant le moyen de libération (85) dans le temps.

**35.** Dispositif selon la revendication 33 ou 34, **caractérisé en ce que** le moyen de libération (85) est un aimant de levage ou un aimant plongeant.

**36.** Dispositif selon l'une des revendications 33 à 35, **caractérisé en ce que** le moyen de forçage du contact en ouverture (80) comporte un accumulateur à ressort.

**37.** Dispositif selon l'une des revendications 20 à 36, **caractérisé en ce que** les autres moyens comprennent un dispositif d'évaluation qui, pour interrompre la poursuite du fonctionnement, ouvre un élément de commutation monté en série avec le contact principal dans la voie de passage du courant.

**38.** Dispositif selon l'une des revendications 20 à 37, **caractérisé en ce que** les autres moyens comprennent un dispositif de commande pour commander l'aimant de commande, lequel dispositif interrompt la ligne de commande vers l'aimant de commande pour interrompre la poursuite du fonctionnement.

**39.** Appareil de commutation qui exécute le procédé selon l'une des revendications 1 à 19 pour la commutation sûre de consommateurs, l'appareil de commutation étant un contacteur ou un disjoncteur ou une dérivation compacte.

**40.** Appareil de commutation pour la commutation sûre de consommateurs avec un dispositif selon l'une des revendications 20 à 38, l'appareil de commutation étant un contacteur ou un disjoncteur ou une dérivation compacte.

**41.** Appareil de commutation selon la revendication 39 ou 40, **caractérisé en ce que** l'appareil de commutation est un l'appareil de commutation tripolaire avec trois contacts principaux pour enclencher et couper trois voies de passage du courant avec un aimant de commande.

# FIG 1

```
    ┌─────────────┐
    │ Ausschalten │
    └──────┬──────┘
           │
           ▼
    ┌─────────────┐
    │  Schritt a  │
    └──────┬──────┘
           │
           ▼
    ┌─────────────┐
    │  Schritt b  │
    └─────────────┘
```

# FIG 2

## FIG 3

FIG 4

## FIG 5

FIG 6

L1-L3

A3

42

41

43

45

1

46

47

A4

44

# FIG 7

FIG 8

FIG 9

FIG 10

L1-L3

73

81  82  83  80

75

96  95

92

74

1

97

91

93

L1-L3

Uc  94

Uc>Umin

A5  A6

FIG 11

FIG 12

## FIG 13

L1-L3

73

82  83  80

81

A7,A8

86  85

72

75

78

86

74

76  77

A5  A6

1

L1-L3

FIG 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0832496 B
- US 5455733 A
- EP 1298689 A
- US 4737749S A